# EUROPEAN PATENT SPECIFICATION

(11) **EP 4 276 799 B1**
(45) Date of publication and mention of the grant of the patent: **17.12.2025**
(21) Application number: 22901495.6
(22) Date of filing: 26.07.2022
(51) Int. Cl.: G09B 9/00, G09B 19/24, G09B 5/02, H01M 50/178, H01M 50/531, H01M 50/557, H01M 50/186, H01M 10/04

(54) **PACKAGE SIMULATION APPARATUS AND METHOD FOR SECONDARY BATTERY PRODUCTION**
VERPACKUNGSSIMULATIONSVORRICHTUNG UND VERFAHREN ZUR HERSTELLUNG EINER SEKUNDÄRBATTERIE
APPAREIL DE SIMULATION DE BOÎTIER ET PROCÉDÉ DE PRODUCTION DE BATTERIES SECONDAIRES

(30) Priority: 01.12.2021 KR 20210170136
(43) Date of publication of application: 15.11.2023
(73) Proprietor: LG Energy Solution, Ltd., Seoul 07335 (KR)
(72) Inventor: KWON, Min Hee, Daejeon 34122 (KR); JO, Moon Kyu, Daejeon 34122 (KR); JUNG, Daewoon, Daejeon 34122 (KR); KIM, Youngduk, Daejeon 34122 (KR); KIM, Nam Hyuck, Daejeon 34122 (KR); JEON, Su Ho, Daejeon 34122 (KR)
(74) Representative: BCKIP Part mbB
(86) International application number: PCT/KR2022/010983
(87) International publication number: WO 2023/101134

(56) References cited:
- WO-A1-93/08552
- CA-A1- 3 103 277
- CN-A- 107 103 811
- JP-A- 2010 231 792
- KR-A- 20180 073 116
- US-A1- 2015 032 497
- US-A1- 2021 043 011

## Description

### TECHNICAL FIELD

The present invention generally relates to a package simulation apparatus and method for secondary battery production as well as a computer program, and, this disclosure more generally relates to a package simulation apparatus and method of training secondary battery production workers.

### BACKGROUND ART

Due to the recent growth of the electric vehicle market, the demand for developing and producing secondary batteries is rapidly increasing. The number of production plants for secondary battery production is also growing in response to the increase in demand for secondary batteries. However, the industry is experiencing a significant shortage of skilled workers for operating secondary battery production plants.

Meanwhile, in the past, training and education of new workers were carried out in such a way of learning a skill by watching experienced workers, but it became difficult to train and educate new workers for a long time due to the busy production schedule of secondary batteries. In addition, it is difficult to find a sufficient number of skilled workers due to the frequent resignation of workers. In addition, even if a worker is trained in a general method of operating a factory, it is not easy for the worker to immediately respond to various defect situations that may occur during factory operation.

US 2021/0 043 011 describes an immersive ecosystem that includes a virtual reality (VR) headset and sensors to create an interactive learning environment. The system uses artificial intelligence (AI) to modify 3D renderings based on user responses measured by sensors like EEG and heart rate monitors. This technology is applicable across various fields such as training, evaluation, and treatment, providing real-time feedback and personalized experiences. The AI engine adapts the VR environment to optimize user performance by adjusting 3D assets based on cognitive load and proficiency. The system is designed to enhance learning and performance in scenarios like military training, medical evaluations, and addiction treatment.

CA 3103277 describes a virtual reality training and evaluation system designed to provide immersive training experiences for skilled workers in hazardous fields like electrical line work and construction. The system includes a visual display device, user input devices, processors, memory, and network communication. It simulates virtual environments where users perform tasks, and their interactions are monitored against predefined safety and efficiency criteria. The system provides evaluations based on user performance, aiming to enhance training by offering realistic, hands-on experiences in a safe virtual setting. It supports multiple users and can be used for certification and workforce resource management.

JP 2010-231792 describes a remote training system for semiconductor manufacturing equipment. The system allows users to receive training via a user terminal connected to an equipment training server. It provides both theoretical and practical training, including simulations of semiconductor manufacturing processes. The system aims to deliver timely training on the latest technology to users worldwide, reducing travel costs and time. It also includes features for user authentication, access restriction, and data encryption to ensure secure and effective training.

KR 2018 0073116 A) describes an apparatus for generating a virtual FINEX process and a method for training workers in the FINEX process. The FINEX process is a method for producing molten iron by omitting the coke and sintering processes, thus reducing costs. The document describes a virtual FINEX process generation device that can create a highly realistic virtual FINEX process based on various conditions. It includes a process design configuration manager and a simulator configuration manager to perform virtual experiments and generate a virtual FINEX process. The system aims to efficiently train workers by simulating the FINEX process, improving productivity and safety, and reducing costs and time associated with actual implementation.

US 2015/0032497 A1 describes a manufacturing line simulation device and a data input assistance method. The document describes the aim to streamline the process of creating manufacturing line simulation models by reducing the time and effort required for data input. It introduces a system that uses a library of model items and an input item association table to prioritize and organize input data, minimizing redundant entries. The device includes components for presenting model libraries, calculating input priorities, receiving user inputs, and generating simulation models.

CN 107 103 811 A describes a virtual testing teaching platform designed for industrial ultra-thin material production testing equipment. The platform integrates actual industrial production lines and testing equipment with virtual dynamic simulation and application software. It aims to enhance students' hands-on skills by combining theoretical knowledge with practical experience in a virtual environment. The platform includes a virtual simulation laboratory, 3D simulation testing equipment, and a virtual testing data module. It allows students to access and interact with virtual experiments through a website, using software like Matlab for data analysis and processing. The system provides a cost-effective, flexible, and comprehensive approach to teaching and training in electronic information engineering and related fields.

WO 93/08552 A1 describes an automated industrial process simulator designed for training users on complex industrial equipment. The system includes simulated displays with graphical overlays to depict controls and displays of the equipment. Users interact with the system via touch-sensitive screens, which simulate the operation of actual equipment controls. The simulator operates in both free play and procedural modes, providing real-time audio, visual, and text feedback based on user interactions. The system aims to offer realistic training experiences without the need for taking actual industrial equipment offline.

### DESCRIPTION OF THE INVENTION

### TECHNICAL OBJECTIVES

The object of the present invention is to provide a package simulation apparatus and method for secondary battery production, as well as a computer program stored in a computer-readable medium to improve production of secondary batteries and reduce losses due to occurrence of defects. This object is solved by the attached independent claims and further embodiments and improvements of the invention are listed in the attached dependent claims. Hereinafter, up to the "brief description of the drawings", expressions like "...aspect according to the invention", "according to the invention", or "the present invention", relate to technical teaching of the broadest embodiment as claimed with the independent claims. Expressions like "implementation", "design", "optionally", "preferably", "scenario", "aspect" or similar relate to further embodiments as claimed, and expressions like "example", "...aspect according to an example", "the disclosure describes", or "the disclosure" describe technical teaching which relates to the understanding of the invention or its embodiments, which, however, is not claimed as such..

### TECHNICAL MEANS

The present invention is implemented in various ways including an apparatus and method, as well as a computer program stored in a computer-readable medium.

A package simulation apparatus for secondary battery production according to the invention includes: a memory configured to store at least one instruction; and at least one processor configured to execute the at least one instruction stored in the memory to perform operations. The operations include executing an apparatus operating unit comprising a 3D package apparatus related to secondary battery production; checking quality of a material produced by the 3D package apparatus; executing a facility operating unit comprising a plurality of adjustment parameters for determining an operation of the 3D package apparatus; obtaining at least one of first user action information obtained through the apparatus operating unit or first user condition information obtained through the facility operating unit; determining at least one of a material checking, the operation of the 3D package apparatus or a self-inspection based on at least one of the first user action information or the first user condition information; and executing the operation of the 3D package apparatus.

According to an embodiment of the present disclosure, the meterial checking includes checking at least one of a lead, an aluminum pouch, or an insulating tape.

According to an embodiment of the present disclosure, the operations further include performing at least one of tab welding, aluminum pouch forming, cell insertion, electrolyte filling, or V-sealing.

According to an embodiment of the present disclosure, the operations further include inspecting at least one of a welding tensile strength, a tab condition, a tab position, a lead film protruding position, a lead center, a sealing position, a sealing thickness, a terrace width, or a cup sealing gap.

According to an embodiment of the present disclosure, the operations further include determining one or more quality parameters for determining the quality of the material produced by the 3D package apparatus; calculating a value corresponding to the one or more quality parameters based on the operation of the 3D package apparatus ; and outputting quality information related to the quality of the material produced by the 3D package apparatus based on the value corresponding to the one or more quality parameters.

According to an embodiment of the present disclosure, the operations further include determining one or more defect scenarios related to the quality of the material produced by the 3D package apparatus; and changing at least one of the operation of the 3D package apparatus or quality information related to the quality of the material based on the one or more defect scenarios.

According to an embodiment of the present disclosure, the one or more defect scenarios include at least one of a sealing groove defect scenario in which an x-axis groove position of the material is out of a boundary of a preset specification, a first sealing thickness defect scenario in which a sealing thickness in at least one measurement point among a plurality of measurement points of the material is out of an upper limit or a lower limit of the preset specification and a deviation in sealing thicknesses between the plurality of measurement points is less than or equal to a preset reference value, or a second sealing thickness defect scenario in which the sealing thickness in the at least one measurement point among the plurality of measurement points of the material is out of the upper limit or the lower limit of the preset specification and the deviation in sealing thicknesses between the plurality of measurement points is greater than the preset reference value.

According to an embodiment of the present disclosure, the operations further include executing at least one of the sealing groove defect scenario, the first sealing thickness defect scenario, or the second sealing thickness defect scenario; obtaining at least one of second user action information of touching or dragging at least part of an area of the 3D package apparatus or second user condition information of changing one of the plurality adjustment parameters of the facility operating unit; correcting the 3D package apparatus based on at least one of the obtained second user action information or second user condition information; calculating a value corresponding to one or more quality parameters related to quality of the material produced by the corrected 3D package apparatus; and correcting quality information related to the quality of the material produced by a corrected 3D package apparatus based on the value corresponding to the one or more quality parameters.

According to an embodiment of the present disclosure, the operations further include obtaining third user action information of touching or dragging at least part of an area corresponding to a quality check of the material produced by the 3D package apparatus; and outputting a defect cause of the material based on the third user action information.

According to an embodiment of the present disclosure, the operations further include outputting guide information including condition information and action information related to resolving the one or more defect scenarios.

A package simulation method for secondary battery production according to the invention, being executed by at least one processor, includes: executing an apparatus operating unit comprising a 3D package apparatus related to secondary battery production; checking quality of a material produced by the 3D package apparatus; executing a facility operating unit comprising a plurality of adjustment parameters for determining an operation of the 3D package apparatus; obtaining at least one of first user action information obtained through the apparatus operating unit or first user condition information obtained through the facility operating unit; determining at least one of a material checking, the operation of the 3D package apparatus, or a self-inspection based on at least one of the first user action information or the first user condition information; and executing the operation of the 3D package apparatus.

According to an embodiment of the present disclosure, when the determined operation is the material checking, the executing of the determined operation may include checking at least one of a lead, an aluminum pouch, or an insulating tape.

According to an embodiment of the present disclosure, when the determined operation is the operation of the 3D package apparatus, the executing of the determined operation may include operating at least one of tab welding, aluminum pouch forming, cell insertion, electrolyte filling, or V-sealing.

According to an embodiment of the present disclosure, when the determined operation is the self-inspection, the executing of the determined operation may include inspecting at least one of a welding tensile strength, a tab condition, a tab position, a lead film protruding position, a lead center, a sealing position, a sealing thickness, a terrace width, or a cup sealing gap.

According to an embodiment of the present disclosure, the method may further include: determining one or more quality parameters for determining the quality of the material produced by the 3D package apparatus; calculating a value corresponding to the one or more quality parameters based on the operation of the 3D package apparatus; and outputting quality information related to the quality of the material produced by the 3D package apparatus based on the value corresponding to the one or more quality parameters.

According to an embodiment of the present disclosure, the method may further include: determining one or more defect scenarios among a plurality of defect scenarios related to the quality of the material produced by the 3D package apparatus; and changing at least one of the operation of the 3D package apparatus or quality information related to the quality of the material based on the one or more defect scenarios.

According to a not claimed embodiment of the present method, the one or more defect scenarios include at least one of a sealing groove defect scenario in which an x-axis groove position of the material is out of a boundary of a preset specification, a first sealing thickness defect scenario in which a sealing thickness in at least one measurement point among a plurality of measurement points of the material is out of an upper limit or a lower limit of the preset specification and a deviation in sealing thicknesses between the plurality of measurement points is less than or equal to a preset reference value, or a second sealing thickness defect scenario in which the sealing thickness in the at least one measurement point among the plurality of measurement points of the material is out of the upper limit or the lower limit of the preset specification and the deviation in sealing thicknesses between the plurality of measurement points is greater than the preset reference value.

According to a not claimed embodiment of the present method, the method may further include: executing at least one of the sealing groove defect scenario, the first sealing thickness defect scenario, or the second sealing thickness defect scenario; obtaining at least one of second user action information of touching or dragging at least part of an area of the 3D package apparatus or second user condition information of changing one of the plurality of adjustment parameters of the facility operating unit; correcting the 3D package apparatus based on at least one of the second user action information or the second user condition information; calculating a value corresponding to one or more quality parameters related to quality of the material produced by the corrected 3D package apparatus; and correcting quality information related to the quality of the material produced by a corrected 3D package apparatus based on the value corresponding to the one or more quality parameters.

According to a not claimed embodiment of the present invention, the method may further include, after executing at least one of the sealing groove defect scenario, the first sealing thickness defect scenario, or the second sealing thickness defect scenario: obtaining third user action information of touching or dragging at least part of an area corresponding to a quality check of the material produced by the 3D package apparatus; and outputting a defect cause of the material based on the third user action information.

According to a not claimed embodiment of the present invention, the method may further include outputting guide information including condition information and action information related to resolving the one or more defect scenarios.

The invention also provides a computer program stored in a computer-readable medium is provided to execute the method according to an embodiment of the above method on a computer.

In the following description, features which in the above summary of the invention have been marked as "not claimed" or "according to the invention" are also hereinafter, when they are described and explained with reference to the drawings, to be understood as "not claimed" or "not part of the invention" or "according to the invention". Even if sometimes in the description of the embodiments below, features marked above "according to the invention" or "the invention" are referred to in connection with the words "can" or "may" or other expressions which contain the notion of them being "optional", it should be understood that indeed such features are considered essential to the invention as claimed and not optional.

### EFFECTS OF THE INVENTION

In various embodiments of the present disclosure, a user performing secondary battery production may perform training related to a method of operating a secondary battery production apparatus, a method of handling a defect situation, and so on through a simulation apparatus before being put into work; through training of the user, the loss due to the occurrence of defects may be considerably reduced so that the efficiency of the secondary battery production task may be improved effectively.

In various embodiments of the present disclosure, by generating a defect scenario based on error information in an actual apparatus, the simulation apparatus may effectively generate training contents optimized for actual work environments.

In various embodiments of the present disclosure, a simulation apparatus may generate and provide a defect scenario having various values related to the malfunction of a secondary battery production apparatus to the user; accordingly, the user may deal with a malfunction situation that may occur in an actual apparatus without help from others and may effectively learn how to respond to various situations.

In various embodiments of the present disclosure, a user may easily learn how to operate a secondary battery production apparatus through the simulation progressed step by step according to the user's task skill level.

In various embodiments of the present disclosure, a user may easily identify and process a defect scenario for which the user lacks training; thus, the user may be trained only in the defect scenario for which the user has low work skills.

In various embodiments of the present disclosure, a user may effectively improve the ability to respond to defects by training using a defect scenario generated based on a malfunction occurring in an actual work environment.

The technical effects of the present disclosure are not limited to the technical effects described above, and other technical effects not mentioned herein may be understood clearly by those with ordinary knowledge in the art (referred to as a "person with ordinary skills") to which the present disclosure belongs from the appended claims.

### BRIEF DESCRIPTION OF THE DRAWINGS

Embodiments of the present disclosure will be described with reference to the accompanying drawings described below, wherein similar reference numbers denote similar constituting elements, but the present disclosure is not limited thereto.
FIG. 1 illustrates an example in which a user uses a simulation apparatus according to an embodiment of the present disclosure.
FIG. 2 is a functional diagram illustrating an internal structure of a simulation apparatus according to an embodiment of the present disclosure.
FIG. 3 is a block diagram illustrating an example in which a simulation apparatus operates according to an embodiment of the present disclosure.
FIG. 4 illustrates an example of a display screen displayed or output on an apparatus operating unit according to an embodiment of the present disclosure.
FIG. 5 illustrates an example of a display screen displayed or output on an apparatus operating unit according to another embodiment of the present disclosure.
FIG. 6 illustrates an example of a display screen displayed or output on an apparatus operating unit according to yet another embodiment of the present disclosure.
FIG. 7 illustrates an example of a sealing position of a cell in which a sealing groove defect scenario has occurred according to an embodiment of the present disclosure.
FIG. 8 illustrates an example of a sealing unit in which a sealing groove defect scenario has occurred according to an embodiment of the present disclosure.
FIG. 9 illustrates an example in which a sealing thickness defect scenario in which a deviation is equal to or less than a reference value has occurred according to an embodiment of the present disclosure.
FIG. 10 illustrates an example in which a sealing thickness defect scenario in which a deviation is greater than a reference value has occurred according to an embodiment of the present disclosure.
FIG. 11 illustrates an example in which a defect scenario has occurred according to an embodiment of the present disclosure.
FIG. 12 illustrates an example in which operational capability information and a test result are generated according to an embodiment of the present disclosure.
FIG. 13 illustrates an example of a simulation method for secondary battery production according to an embodiment of the present disclosure.
FIG. 14 illustrates an example of a simulation method of a package apparatus for secondary battery production according to an embodiment of the present disclosure.
FIG. 15 illustrates an example of a method of calculating a test result according to an embodiment of the present disclosure.
FIG. 16 illustrates an example of a method of generating a defect scenario according to an embodiment of the present disclosure.
FIG. 17 illustrates an exemplary computing device for performing the method and/or embodiments.

### [Description of Reference numeral]

100: Simulation apparatus
110: User
120: Facility operating unit
130: Apparatus operating unit

### MODES FOR IMPLEMENTING THE INVENTION

Hereinafter, embodiments of the present invention will be described in detail with reference to appended drawings.

In the accompanying drawings, identical or corresponding constituting elements are assigned the same reference numbers. In addition, overlapping descriptions of the same or corresponding constituting elements may be omitted in the description of the embodiments below. However, even if descriptions regarding a constituting element are omitted, it should not be interpreted that the constituting element is not included in the corresponding embodiment.

The advantages and features of the present disclosure, and a method of achieving them will be clearly understood with reference to the embodiments described together with appended drawings.

Terms used in the present disclosure will be briefly defined, and disclosed embodiments will be described in detail. Terms used in the present disclosure have been selected as much as possible from general terms relevant to the functions of the present disclosure and currently in wide use; however, the selection of terms may be varied depending on the intention of those persons skilled in the corresponding field, precedents, or emergence of new technologies. In addition, in a particular case, some terms may be selected arbitrarily by the applicant, and in this case, detailed definitions of the terms will be provided in the corresponding description of the present disclosure. Therefore, the terms used in the present disclosure should be defined not simply by their apparent name but based on their meaning and context throughout the present disclosure.

In the present disclosure, a singular expression should be understood to include a plural expression unless the context explicitly indicates a singular expression. In addition, a plural expression should be understood to include a singular expression unless the context explicitly indicates a plural expression. Throughout the disclosure, unless otherwise explicitly stated, if a particular element is said to include some particular element, it means that the former may further include other particular elements rather than exclude them.

The term "comprises (includes)" and/or "comprising (including)" used in the present disclosure indicates the existence of features, steps, operations, components, and/or constituting elements; however, the term does not exclude addition of one or more other functions, steps, operations, components, constituting elements, and/or a combination thereof.

In the present disclosure, when a particular constituting element is referred to as being "coupled to," "combined with," "connected to," "related to," or as "responding to" any other constituting element, the particular constituting element may be directly coupled to, combined with, connected to, and/or related to, or may directly respond to the other constituting element; however, the present disclosure is not limited to the relationship. For example, there may be one or more intermediate constituting elements between a particular constituting element and another constituting element. In addition, in the present disclosure, "and/or" may include one or more of the listed items or a combination of at least a portion of one or more of the listed items.

In the present disclosure, the terms such as "first" and "second" are introduced to distinguish one constituting element from the others, and thus the constituting element should not be limited by those terms. For example, a "first" constituting element may be used to indicate a constituting element in a form similar to or the same as a "second" constituting element.

In the present disclosure, a "secondary battery" may refer to the battery made using a material in which the redox process between a current and the material may be repeated several times. For example, to produce a secondary battery, processing such as mixing, coating, roll pressing, slitting, notching and drying, lamination, folding and stacking, lamination and stacking, packaging, charging and discharging, degassing, double side folding/single side folding, characteristics inspection (end of line), and the like may be performed. In this case, separate production equipment (apparatus) for performing each process may be used. At this time, each production equipment may be operated according to adjustment parameters and configuration values set or changed by a user.

In the present disclosure, a "user" may refer to a worker who performs secondary battery production and operates secondary battery production equipment and may include a user training through a simulation apparatus for secondary battery production equipment. In addition, a "user account" is an ID created to use the simulation apparatus or assigned to each user; the user may log into the simulation apparatus using the user account and perform a simulation, but the present disclosure is not limited thereto.

In the present disclosure, the "facility operating unit," "apparatus operating unit," and "quality checking unit" are software programs included in the simulation apparatus or displayed on an input/output device related to the simulation apparatus and/or an input/output device and may refer to a device and/or a program outputting an image or a video of a 3D model apparatus or receiving various inputs from a user and delivering the received inputs to the simulation apparatus.

In the present disclosure, the "3D model apparatus" is a virtual apparatus that implements actual secondary battery production equipment, which may operate in a way that images, videos, or animations of the virtual apparatus are executed, modified, and/or corrected based on the information input by a user. In other words, the "operation of the 3D model apparatus" may include images, videos, and animations of a virtual apparatus executed, modified, and/or corrected. For example, the 3D model apparatus may include apparatus for performing mixing, coating, roll pressing, slitting, notching and drying, lamination, folding and stacking, lamination and stacking, packaging, charging/discharging, degassing, double side folding/single side folding, characteristics inspection (end of line), and the like. Additionally or alternatively, the 3D model apparatus may be implemented as a 2D model apparatus. In other words, in the present disclosure, the 3D model apparatus is not limited to a 3D model but may include a 2D model. Accordingly, the 3D model apparatus may include terms such as a 2D model apparatus, an animation model apparatus, and a virtual model apparatus.

In the present disclosure, "user condition information" may include a user input that sets or modifies at least part of conditions and/or values among adjustment parameters or may correspond to the information generated by an arbitrary algorithm predetermined based on the corresponding user input.

In the present disclosure, "user action information" may include a user input such as a touch input, a drag input, a pinch input, and a rotation input performed on at least part of the 3D model apparatus or may correspond to the information generated by an arbitrary algorithm predetermined based on the corresponding user input.

In the present disclosure, a "defect scenario" may be a scenario that changes the operation of a 3D model apparatus within a malfunction range or includes values or conditions for changing quality information of a material determined by the operation of the 3D model apparatus into a defect range. For example, when a defect scenario occurs during the operation of the simulation apparatus, the operation or quality information of the 3D model apparatus may be changed based on the generated defect scenario. In addition, when the operation or quality information of the 3D model apparatus changed by the defect scenario is corrected to lie within a normal range, the corresponding defect scenario may be determined as having been resolved.

In the present disclosure, the "training scenario" may include a scenario for operating secondary battery production equipment. For example, suppose the secondary battery production equipment is a package apparatus; in that case, the training scenario may include a material checking training, a facility operation training, a self-inspection training, a facility stop training, a cell data deletion training, a lot termination and lot exchange training, and the like. In addition, the training scenario may include training for inspecting each mechanical part constituting the 3D model apparatus and changing the state, and training for adjusting adjustment parameters. The training scenario may include a defect scenario.

In the present disclosure, the "mixing process" may be a process of producing slurry by mixing active material, a binder, and other additives with a solvent. For example, a user may determine or adjust the addition ratio of active material, conductive material, additives, and a binder to produce slurry of specific quality. In addition, in the present disclosure, the "coating process" may be a process of applying the slurry on the foil with a particular amount and shape. For example, a user may determine or adjust a coater apparatus's die or slurry temperature to perform coating with a quantity and a shape of specific quality.

In the present disclosure, the "roll pressing process" may be a process in which coated electrodes are passed between two rotating upper and lower rolls and pressed to a certain thickness. For example, a user may determine or adjust the spacing between rolls to maximize the cell capacity by increasing the electrode density through the roll pressing process. In addition, in the present disclosure, the "slitting process" may be a process of passing electrodes between two upper and lower rotating knives and cutting the electrodes to have a predetermined width. For example, a user may determine or adjust various adjustment parameters to maintain a constant electrode width.

In the present disclosure, the "notching and drying process" may be a process of removing moisture after punching out an electrode into a particular shape. For example, a user may determine or adjust a cutting height, a length and the like to punch the electrode into a particular shape with specific quality. In addition, in the present disclosure, the "lamination process" may be a process of sealing and cutting the electrode and the separator. For example, a user may determine or adjust a value corresponding to the x-axis and a value corresponding to the y-axis to perform cutting at a specific quality.

In the present disclosure, the "package process" may be a process of attaching a lead and a tape to an assembled cell and packaging the assembled cell in an aluminum pouch. A cell that has undergone the packaging process may be subjected to a charging/discharging process, and in this case, a gas may be generated in the cell. The "package process" may be a process of discharging the gas generated in the cell in the charging/discharging process outside and resealing the cell.

In the present disclosure, the 'double side folding' process may be a process of folding opposite ends or one end of an aluminum pouch of the charging/discharging-completed cell two times, and the 'single side folding' process may be a process of folding opposite ends or one end of an aluminum pouch of the charging/discharging-completed cell one time.

In addition, in the present disclosure, the 'characteristics inspection process' may be a process of checking characteristics such as thickness, weight, width, length, and insulation voltage of a cell using a measurement device before shipment. For the processes above, a user may adjust conditions or values of various adjustment parameters or change configuration values corresponding to the apparatus so that each process is performed with specific quality within a normal range.

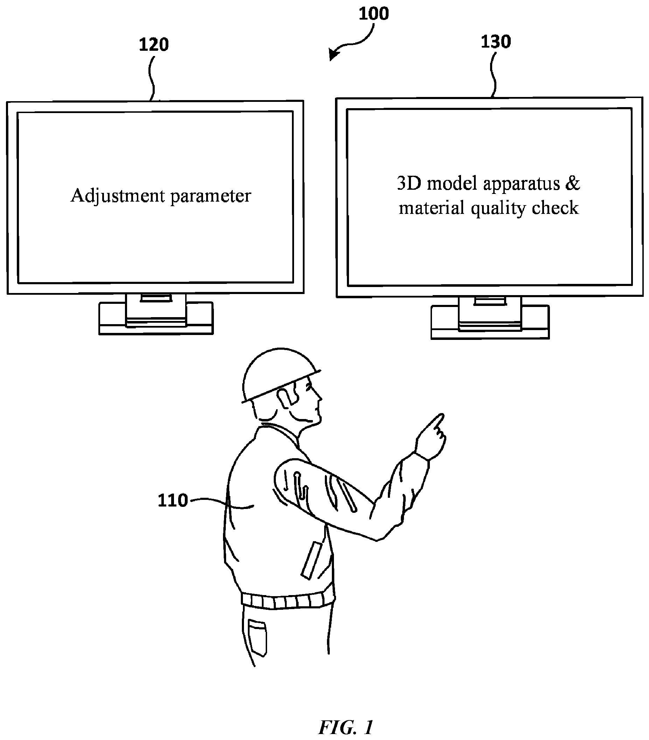

FIG. 1 illustrates an example in which a user 110 uses a simulation apparatus 100 according to an embodiment of the present disclosure. As illustrated in the figure, the simulation apparatus 100 is used for training a secondary battery production worker (e.g., user 110) and may include, for example, a facility operating unit 120 and an apparatus operating unit 130. For example, the user 110 may operate the simulation apparatus 100 which implements the actual secondary battery production equipment virtually (e.g., 2D, 3D, etc.) and learn how to use the secondary battery production equipment or how to respond when the quality of the manufactured product is degraded.

According to an embodiment, the facility operating unit 120 may include a plurality of adjustment parameters for determining the operation of the 3D model apparatus displayed on the apparatus operating unit 130, and the user 110 may execute, change, and/or correct the operation of the 3D model apparatus by changing at least part of the conditions among a plurality of adjustment parameters. In other words, the operation of the 3D model apparatus may be changed or corrected adaptively as the adjustment parameters input by the user 110 are changed.

The apparatus operating unit 130 may include a 3D model apparatus related to the production of secondary batteries. Here, the 3D model apparatus may include, but not limited to, a 3D model related to secondary battery production equipment such as, but not limited to, a mixer, a coater, a roll presser, a slitter, a notching and drying apparatus, a lamination apparatus, a folding and stacking apparatus, a lamination and stacking apparatus, a packaging apparatus, a charge/discharge apparatus, a degas apparatus, and a double/single side folding apparatus and a characteristics inspection apparatus, and may further include a 3D model of any other apparatus used for the production of secondary batteries.

According to an embodiment, the user 110 may manipulate the 3D model apparatus or change the configuration of the 3D model apparatus by applying a touch input, a drag input, or a pinch input to the 3D model apparatus (at least part of the 3D model apparatus) included in the apparatus operating unit 130. Furthermore, the user 110 may check or enlarge/reduce an arbitrary area of the 3D model apparatus through view switching, operate the 3D model apparatus by performing a touch input, or change the configuration of the 3D model apparatus. Here, it is assumed that the apparatus operating unit 130 displays a 3D model apparatus related to secondary battery production; however, the present disclosure is not limited to the assumption, and thus, an apparatus related to a specific process in the secondary battery production process may be implemented and displayed as a 2D model apparatus.

The apparatus operating unit 130 may include means for checking quality of a material produced by the 3D model apparatus. After changing at least one adjustment parameter from among a plurality of adjustment parameters in the facility operating unit 120, the user may check the quality of the material in the apparatus operating unit 130 and learn a change in the quality of the material caused by the adjustment of each adjustment parameter.

At least one of the facility operating unit 120 or the apparatus operating unit 130 may include quality information related to the quality of the material produced by the 3D model apparatus. Here, the quality information may be generated by performing an operation on the quality parameter based on a predetermined criterion and/or algorithm. The user 110 may check the quality information of the material generated in response to changing the adjustment parameter or manipulating the 3D model apparatus through the at least one of the facility operating unit 120 or the apparatus operating unit 130. Additionally or alternatively, in a specific process according to the secondary battery production process, a separate quality check unit displaying quality information of the material may be independently configured.

According to an embodiment, the quality information may be displayed in association with the 3D model apparatus of the apparatus operating unit 130, checked by a specific operation of the 3D model apparatus, additionally displayed on a screen of part of the 3D model apparatus, or displayed as a change in the parameter setting value of the facility operating unit 120. For example, when a button for quality check displayed on the apparatus operating unit 130 is selected, quality information may be displayed or output on at least one of the apparatus operating unit 130 or the facility operating unit 120. In another example, the quality information may be displayed or output in a manner of a color change of at least part of the 3D model apparatus, or an alarm. In another example, when a malfunction occurs in the operation of the 3D model apparatus or when a defect occurs in the quality of the material produced by the 3D model apparatus, the malfunctioned/defective area may be immediately displayed or output on the 3D model apparatus. In another example, a parameter value related to the quality of the material produced by the 3D model apparatus may be displayed or output on the facility operating unit 120. For example, if the secondary battery production equipment is a package sealing apparatus, a lead and a tape may be attached to an assembled cell and sealed for packaging in an aluminum pouch; in this case, a sealing position and a sealing thickness are important determinants of the quality of the material. The factors that affect the sealing position may include a position of a sealing unit, and the factors that affect the sealing thickness may include sealing tool contamination, bolt loosening, heater rod temperature (sealing temperature), sealing pressure, contact time, sealing stopper, feeler gauge, and the like. In the event of a malfunction of the relevant factors or an error in inputting the adjustment parameter value, defects such as sealing position and sealing thickness may be displayed on at least one of the 3D model apparatus or the facility operating unit or an alarm may be output, and optionally, for more accurate quality check, the user may intuitively identify a location of the defect and a cause of the defect through the quality check process of the 3D model apparatus.

In FIG. 1, the simulation apparatus 100 is illustrated as including one facility operating unit 120 and one apparatus operating unit 130; however, the present disclosure is not limited to the specific illustration, and an arbitrary number of facility operating units 120 and apparatus operating units 130 may be employed depending on the type of 3D model apparatus related to the simulation apparatus 100, and an arbitrary number of quality checking units may be further included. With such a configuration, the user 110 performing secondary battery production may be trained in a method of operating the secondary battery production equipment, a method of responding to a defect situation before being put into work, and the like; by training the user 110 as described above, loss due to the occurrence of defects may be considerably reduced, and thus, the efficiency of the secondary battery production task may be improved effectively.

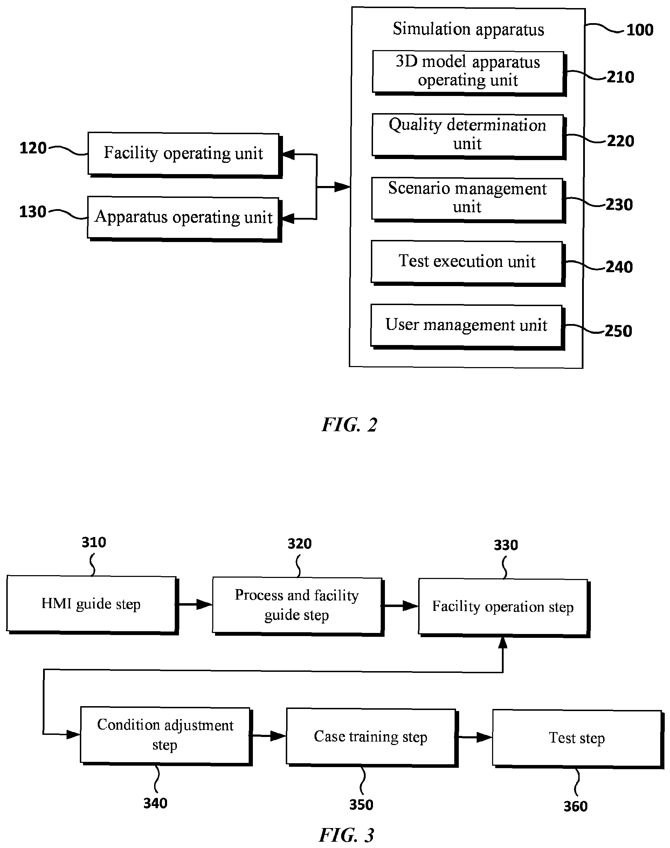

FIG. 2 is a functional diagram illustrating an internal structure of a simulation apparatus 100 according to an embodiment of the present disclosure. As illustrated in the figure, the simulation apparatus 100 (e.g., at least one processor of the simulation apparatus 100) may include, but not limited to, a 3D model apparatus operating unit 210, a quality determination unit 220, a scenario management unit 230, a test execution unit 240, and a user management unit 250. The simulation apparatus 100 may communicate with the facility operating unit 120 and the apparatus operating unit 130, and exchange data and/or information related to the 3D model apparatus.

The 3D model apparatus operating unit 210 may execute, change, and/or correct the operation of the 3D model apparatus displayed on the apparatus operating unit 130 according to a user's manipulation. In addition, the operation of the facility operating unit 120 may be executed, changed and/or corrected based on the execution, change and/or correction of the operation of the model apparatus. According to an embodiment, the 3D model apparatus operating unit 210 may obtain or receive user action information and/or user condition information using information input from the user (e.g., a secondary battery production worker). Then, the 3D model apparatus operating unit 210 may determine or change the operation of the 3D model apparatus using the obtained or received user action information and/or user condition information.

According to an embodiment, the user action information is generated based on a user input such as touching and/or dragging at least part of an area of the 3D model apparatus included in the apparatus operating unit 130 and may include the information on the amount of change in a setting value of the 3D model apparatus according to the user input. For example, when the 3D model apparatus is a package sealing apparatus for secondary battery production, the user may touch or drag, for example, the entire sealing unit and a lower portion of the sealing unit to move it to the position, may touch or drag a sealing tool to remove contaminants attached to a sealing tool, may add or remove a shim ring to or from a sealing tool stopper by touching or dragging a sealing tool stopper area to adjust a height of the sealing tool stopper, may touch or drag a bolt area to tighten or loosen a bolt, may touch or drag a feeler gauge area to insert or remove a feeler gauge, and may touch a specific area of the 3D model apparatus to enlarge or reduce the corresponding area. In this case, the user action information based on the sealing unit, the sealing tool, the sealing tool stopper, the bolt, the feeler gauge, the specific area, and the like may be generated.

According to an embodiment, the user condition information is generated based on a user input that changes conditions and/or values of at least part of parameters among a plurality of adjustment parameters included in the facility operating unit 120 and may include information about an amount of change in a condition value to determine the operation of the 3D model apparatus according to the user input. For example, when the 3D model apparatus is a package sealing apparatus for secondary battery production, the user may change, for example, a sealing temperature parameter, a sealing pressure parameter, a contact time parameter, and the like to a predetermined value; in this case, user condition information based on the changed value of the sealing temperature parameter, the sealing pressure parameter, and the contact time parameter may be generated.

As described above, when the operation of the 3D model apparatus is executed based on the user condition information and/or the user action information, the quality determination unit 220 may determine or generate quality information related to the quality of a material produced by the operation of the 3D model apparatus. In other words, when the 3D model apparatus operates (when animations or images are played to operate the 3D model apparatus), the quality information may be determined or generated differently according to a setting value or a condition value of the corresponding 3D model apparatus. In other words, the user may change or adjust the quality of a material produced by a 3D model apparatus by changing adjustment parameters or setting at least part of an area of the corresponding 3D model apparatus using a touch input.

According to an embodiment, the quality determination unit 220 may determine or extract one or more quality parameters for determining the quality of a material produced by the 3D model apparatus, and while the operation of the 3D model apparatus is in execution, a value corresponding to each of one or more quality parameters determined based on the operation of the 3D model apparatus under execution may be calculated. Here, a predetermined, arbitrary algorithm may calculate the value corresponding to the quality parameter. In addition, the quality determination unit 220 may generate quality information related to the quality of a material produced by the 3D model apparatus based on a value corresponding to each of the one or more quality parameters calculated. For example, in a case where the 3D model apparatus is a package sealing apparatus for secondary battery production, when the user adjusts the sealing temperature parameter, the sealing pressure parameter and/or the contact time parameter, a value corresponding to the sealing thickness may be calculated. In this case, the quality determination unit 220 may generate or output the quality information of the material including the calculated sealing thickness.

According to an embodiment, a defect scenario related to a malfunction of the 3D model apparatus may occur during or before the operation of the 3D model apparatus. When a defect scenario occurs as described above, at least part of the setting values, condition values, and quality information of the 3D model apparatus may be changed to lie within an abnormal range based on the defect scenario.

According to an embodiment, the scenario management unit 230 may determine one or more defect scenarios among a plurality of defect scenarios related to a malfunction of the 3D model apparatus and a plurality of defect scenarios related to the quality of the material and, based on the determined one or more defect scenarios, may change at least one of quality information related to the operation of the 3D model apparatus or quality of the material. For example, when the 3D model apparatus is a package sealing apparatus, the plurality of defect scenarios may include a sealing groove defect, a sealing thickness defect, and the like. The sealing thickness defect may include a sealing thickness defect in which a deviation is less than or equal to a reference value and a sealing thickness defect in which the deviation is greater than the reference value, and causes of these defects may be different from each other. In this case, the scenario management unit 230 may determine a defect scenario by extracting at least one from among the defect scenarios such as the sealing groove defect scenario and the sealing thickness defect scenario, and, according to the determined defect scenario, change the adjustment parameter, operation, and quality information of the 3D model apparatus.

According to an embodiment, when a defect scenario occurs, the user may change the adjustment parameter or the settings of the 3D model apparatus to resolve the occurred defect scenario. In this case, the scenario management unit 230 may receive at least one of user action information or user condition information for resolving the determined one or more defect scenarios and correct the operation of the 3D model apparatus changed based on at least one of the received user action information or user condition information. In addition, while the operation of the corrected 3D model apparatus is in execution, the scenario management unit 230 may calculate a value corresponding to each of a plurality of quality parameters related to the quality of a material produced by the 3D model apparatus based on the operation of the 3D model apparatus in execution and may correct the quality information related to the quality of a material produced by the corrected 3D model apparatus based on the value corresponding to each of the plurality of calculated quality parameters.

Then, the scenario management unit 230 may determine whether one or more defect scenarios have been resolved using the corrected quality information. For example, when the quality of a material falls within a predetermined normal range of a spec, the scenario management unit 230 may determine that the defect scenario has been resolved, but the present disclosure is not limited to the specific operation; when the value of each quality parameter included in the quality information lies within the predetermined normal range of the spec or corresponds to a specific value, the scenario management unit 230 may determine that the defect scenario has been resolved. Additionally or alternatively, when a value calculated by providing each quality parameter to an arbitrary algorithm falls within a predetermined normal range, the scenario management unit 230 may determine that the defect scenario has been resolved.

According to an embodiment, a setting value and a condition value of the 3D model apparatus changed to lie within the range of a malfunction by a defect scenario may be determined in advance for each defect scenario, but the present disclosure is not limited to the specific operation. For example, the defect scenario may be generated based on error information generated when actual secondary battery production equipment malfunctions. In other words, when a malfunction occurs in an external apparatus (e.g., actual secondary battery production equipment) related to the 3D model apparatus, the scenario management unit 230 may obtain error information related to the malfunction and, based on the obtained error information, may generate a defect scenario related to the malfunction of the 3D model apparatus. For example, when a malfunction occurs in folding and stacking, and lamination and stacking processes, which are a preceding process of the packaging in a secondary battery production line, the scenario management unit 230 may obtain a value of each adjustment parameter and a setting value of the apparatus at the time of malfunction as error information. The scenario management unit 230 may generate a defect scenario by changing the value of each adjustment parameter and each setting value of the apparatus obtained from an external device to correspond to the 3D model apparatus. Since a defect scenario occurs based on the error information from an actual apparatus using the configuration above, the simulation apparatus 100 may effectively generate training contents optimized for actual work environments.

According to an embodiment, the test execution unit 240 may determine whether one or more defect scenarios have been resolved using the corrected quality information; when it is determined that one or more defect scenarios have been resolved, the test execution unit 240 may calculate a progress time and a loss value of one or more defect scenarios while one or more defect scenarios are in progress. For example, the loss value may include, for example, a material loss value and may be calculated through a predetermined, arbitrary algorithm based on a user's response time, a user input value, and the like. In addition, the test execution unit 240 may generate operational capability information of the 3D model apparatus for a user account based on the calculated progress time and loss value. Here, the user account may refer to an account of a worker who uses the simulation apparatus 100, and the operational capability information represents the work skill level of the user, which may include a work speed, degree of proximity to a target value, and an evaluation score. Additionally, when the corresponding user solves all predetermined types of defect scenarios, the test execution unit 240 may determine whether the user passes a simulation training based on the operational capability information for each defect scenario.

The user management unit 250 may perform management such as registration, modification, and deletion of a user account related to a user who uses the simulation apparatus 100. According to an embodiment, the user may use the simulation apparatus 100 using the user's registered user account. In this case, the user management unit 250 may store and manage information on whether each defect scenario has been resolved and operational capability information for dealing with each defect scenario in an arbitrary database for each user account. Using the information stored by the user management unit 250, the scenario management unit 230 may extract information related to a specific user account stored in the database and extract or determine at least one scenario among a plurality of defect scenarios based on the extracted information. For example, the scenario management unit 230 may extract only a defect scenario in which the working speed is lower than an average working speed based on the information related to the user account or provide the extracted defect scenario to the corresponding user, but the present disclosure is not limited to the specific operation; the defect scenario may be extracted or determined by another arbitrary criterion or a combination of arbitrary criteria.

In FIG. 2, it is assumed that functional configurations included in the simulation apparatus 100 are different from each other; however, the assumption is intended only to help understand the disclosure, and one computing device may perform two or more functions. In addition, the simulation apparatus 100 of FIG. 2 assumes to be distinguished from the facility operating unit 120 and the apparatus operating unit 130; however, the present disclosure is not limited to the assumption, and the facility operating unit 120 and the apparatus operating unit 130 may be included in the simulation apparatus 100. Using the configuration above, the simulation apparatus 100 may generate a defect scenario having various values related to the malfunction of the secondary battery production equipment and provide the generated scenarios to the user; accordingly, the user may be trained in a method of resolving a malfunction situation that may occur in an actual apparatus without help from others and effectively learn how to respond to each situation.

FIG. 3 is a block diagram illustrating an example in which a simulation apparatus 100 operates according to an embodiment of the present disclosure. As illustrated in the figure, the simulation apparatus (100 in FIG. 1) may operate through processes such as a HMI (Human-Machine Interface) guide step 310, a process and facility guide step 320, a facility operation step 330, a condition adjustment step 340, a case training step 350, and a test step 360. In other words, the user may be trained in a method of operating secondary battery production equipment through the steps 310, 320, 330, 340, 350, 360, and a level test step for a novice user to evaluate operation capability before simulation learning may be added and proceed before the HMI guide step 310.

The HMI guide step 310 may be a step of learning types of various adjustment parameters included in the facility operating unit and a method of manipulating adjustment parameters. For example, a work specification and/or guide information indicating, for example, the types of adjustment parameters and a method of manipulating adjustment parameters may be displayed or output on the facility operating unit, the apparatus operating unit, and the like. Additionally, a portion of the screen may be turned on or activated so that the user may perform a task corresponding to the work specification and/or guide information. In this case, the user may be trained in how to use the facility operating unit by manipulating a condition and/or a value of an arbitrary adjustment parameter corresponding to the work specification and/or guide information. When the user touches a button for a predetermined time according to the work specification and/or guide information or enters a correct value corresponding to an arbitrary parameter, the next step may be performed, or a button that leads to the next step (e.g., NEXT button) may be displayed or activated.

The process and facility guide step 320 may be a step of describing secondary battery production processes or equipment. When the 3D model apparatus is a package apparatus, the process and facility guide step 320 may include description for a loader process, description for a tab welder process, description for an aluminum pouch forming (Al forming) process, description for a cell insertion (Cell Assy) process, description for an electrolyte (EL) filling process, description for a V-sealing process, and description for an unloader process.

The facility operation step 330 may be a step of training an operation of the 3D model apparatus. When the 3D model apparatus is a package apparatus, the facility operation step 330 may be a step of performing at least one of a material checking step, a 3D package operation step, a self-inspection step, a facility stop step, a cell data deletion step, or a lot termination/lot exchange step. In the material checking step, an operation of checking materials required for the package, such as lead, aluminum pouch, and insulating tape may be performed. In the 3D package operation stage, the 3D model apparatus is operated, and an operation such as loading, tab welding, Al forming, Cell Assy, EL filling, V-sealing and unloading may be trained. The self-inspection step is a quality checking operation for a material produced by the 3D model apparatus; after the tab welding, inspection on a welding tensile strength, a tab condition, a tab position and the like may be performed, and after the electrolyte filling and the sealing operation, inspection on a lead film protruding position, a lead center, a sealing position, a sealing thickness, a terrace width, a cup sealing gap, and the like ma be performed.

In the facility operating step 330, the material checking step may be a step of providing the apparatus operating unit 130 with guide information to check materials such as a lead, an aluminum pouch, and an insulating tape, and obtaining user action information to check whether the user has inspected the lead, the aluminum pouch, the insulating tape, and the like. In the facility operation step 330, the 3D package operation step may be a step of providing the apparatus operating unit 130 with guide information to perform a series of operation such as loading, tab welding, Al forming, Cell Assy, EL filling, V-sealing and unloading, and obtaining at least one of user action information or user condition information to check whether the user has performed the corresponding operation. In addition, in the facility operation step 330, the self-inspection step may be a step of providing the apparatus operating unit 130 with guide information to check quality such as a welding tensile strength, a tab condition, a tab position, a lead film protruding position, a lead center, a sealing position, a sealing thickness, a terrace width, a cup sealing gap, and the like, and obtaining at least one of user condition information or user action information to check whether the user has inspected the welding tensile strength, the tab condition, the tab position, the lead film protruding position, the lead center, the sealing position, the sealing thickness, the terrace width, the cup sealing gap, and the like,

The condition adjustment step 340 may be a step of learning a quality change of the material generated by the 3D model apparatus according to a value of the adjustment parameter of the facility operating unit and a state of the apparatus operating unit. The quality of the material is checked in the self-inspection step of the facility operation step 330, and the adjustment parameter value is adjusted or the mechanical part of the 3D model apparatus is checked and corrected in the condition adjustment step 340; subsequently, it may be trained that part of works of the facility operation step is repetitively performed. For example, the condition adjustment step 340 may be a step of learning adjustment of a position of a sealing unit which may determine a sealing groove position of the material in connection with the package sealing operation. In addition, it may be a step of learning cleaning of a sealing tool, checking of the loosening of bolts, checking and adjusting of a heater rod temperature (sealing temperature), adjusting of a sealing pressure, adjusting of a contact time, adjusting of a height of a sealing tool stopper, inserting/removing of a feeler gauge, and the like, which may determine the sealing thickness of the material. In the condition adjustment step 340, guide information may be displayed on the screen of the apparatus operating unit while the user performs each learning, and partial area of the screen of the facility operating unit and/or the apparatus operating unit may be turned on or activated. In this case, the user may be trained in how to input or manipulate a setting value of the facility operating unit and/or the 3D model apparatus corresponding to the guide information. After the user performs one task, the next step may be performed, or a button which leads to the next step (e.g., NEXT button) may be displayed or activated. In addition, in the condition adjustment step 340, the setting value of the facility operating unit may be adjusted and input, or may be corrected by adjusting the mechanical part of the apparatus operating unit, the process may then return to the facility operation step 330 to re-operate the facility, and the quality re-checking inspections, such as the self-inspections, may be performed to check the result of the re-operating.

The case training step 350 may be a step in which the user learns how to check and cope with defects that occur during the operation of the secondary battery production apparatus. For example, in the case of a package sealing operation, a sealing groove defect, a sealing thickness defect and the like may occur, and the causes of each defect may all be different from each other. That is, even in the case of the same sealing thickness defect, the method for solving the corresponding defect may be different for each cause. In the case training step 350, upon occurrence of the defect, a type of adjustment parameter, a value of the adjustment parameter, a setting value of the 3D model apparatus, countermeasures for the mechanical part of the 3D model apparatus and the like that should be manipulated to solve the defect may be displayed or output. The user may process the defect based on the displayed information and learn a defect solving method.

The case training step 350 may be a step in which a user repeatedly processes or resolves each defect scenario or a combination of a plurality of defect scenarios related to a secondary battery production apparatus to master a defect-solving method. For example, the user may directly select one defect scenario among a plurality of defect scenarios and be trained in the selected scenario, but the present disclosure is not limited to the operation; the user may be trained in a defect scenario determined randomly by the simulation apparatus. In such a case, in the case training step 350, guide information including condition information and action information required to solve each defect according to a defect scenario may be displayed or output. Here, when a user manipulates a specific adjustment parameter, changes the setting value of the 3D model apparatus, or manipulates the 3D model apparatus, the operation of the 3D model apparatus and quality of the material related to the 3D model apparatus may be changed in real-time. By checking the changed quality, the user may resolve the defect scenario through repeated training and improve the skill in coping with the defect.

The test step 360 may be a step of evaluating the operational capability of a user by testing the process through which the user resolves a defect scenario. For example, when a user resolves each defect scenario, the operational capability of the user may be measured or evaluated based on, for example, a progress time and a loss value for each defect scenario. The user may additionally learn or be trained for an incomplete defect scenario by checking the operational capability and whether the user has passed the test. In addition, the test step 360 may additionally determine the degree of improvement of the user's skill level by comparing it with a performance evaluation score before simulation training measured in the user's level test step.

Although FIG. 3 assumes that each step is sequentially performed, the present disclosure is not limited to the assumption, and some of the steps may be omitted. In addition, the order of performing the steps may be changed and may be repeated. For example, after the testing step 360, the case training step 350 may be performed again. Based on the configuration, the user may easily learn how to operate the secondary battery production apparatus through the simulation progressed step by step according to the user's task skill.

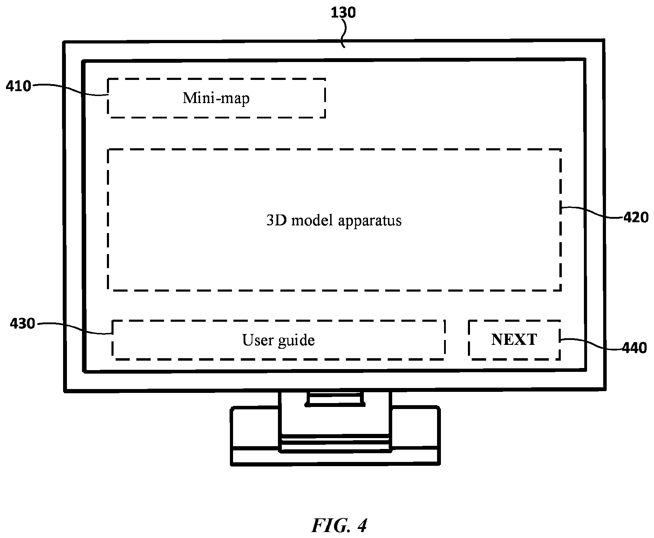

FIG. 4 illustrates an example of a display screen displayed or output on an apparatus operating unit 130 according to an embodiment of the present disclosure. As illustrated in the figure, the apparatus operating unit 130 may display or output text, an image, and a video including a mini-map 410, a 3D model apparatus 420, a user guide 430, and a NEXT button 440 on the display screen. FIG. 4 assumes that the mini-map 410, the 3D model apparatus 420, the user guide 430, and the NEXT button 440 are displayed in a specific area on the display screen, but the present disclosure is not limited to the assumption; each of the text, image, and video may be displayed in an arbitrary area of the display screen.

The mini-map 410 briefly displays the entire package apparatus for secondary battery production, and the approximate position of the area displayed on the 3D model apparatus 420 out of the entire package apparatus is displayed as a rectangular box. When the apparatus displayed on the 3D model apparatus 420 is changed, the position and size of the rectangular box displayed on the mini-map 410 may also be changed in real-time. For example, the mini-map 410 may perform the function of a position guide map of the package apparatus.

The 3D model apparatus 420 may be a 3D image or video that implements the secondary battery production equipment in a 3D form. The 3D model apparatus 420 may operate based on the user condition information and/or user action information input from a user.

The user guide 430 may be the information for guiding a user's next action, which includes information necessary to operate the 3D model apparatus 420, condition information and action information required to solve a defect scenario, and so on. In other words, even when the user does not know how to operate the simulation apparatus, the user may be trained in a method of operating the simulation apparatus and a method of dealing with a defect using the user guide 430.

When the condition value or setting value of the 3D model apparatus is determined or the 3D model apparatus 420 is operated using the displayed user guide 430, the corresponding step is resolved, and the NEXT button 440 for proceeding to the next step may be activated. The user may select the activated NEXT button 440 through, for example, a touch input to perform training corresponding to the next step.

Although not illustrated, the work specification which is a document containing initial setting values and condition values of the 3D model apparatus 420 may be further displayed on the apparatus operating unit 130. The work specification may be predetermined or generated by a particular algorithm. For example, the simulation apparatus may receive and provide the contents of the work specification used to operate actual secondary battery production equipment or generate a new work specification by calculating the initial setting values and condition values of the 3D model apparatus 420 based on a plurality of input work specifications. Here, the 3D model apparatus 420 may be three-dimensional image, video, or the like that implements the secondary battery production equipment in a 3D form. In the apparatus operating unit 130, the results of self-inspection and quality check may be further displayed in a pop-up form, and if necessary, a toolbar including various tool icons (e.g., a wiper towel for cleaning the sealing tool) for operating the 3D model apparatus may be additionally displayed.

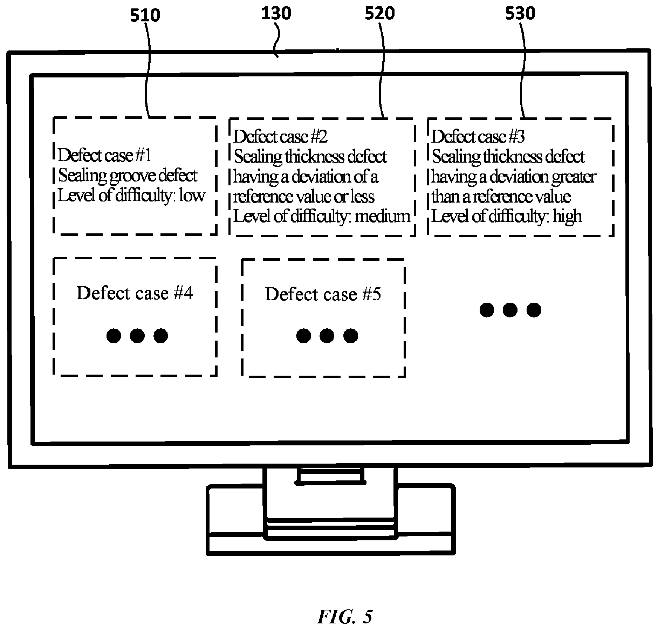

FIG. 5 illustrates an example of a display screen displayed or output on an apparatus operating unit 130 according to another embodiment of the present disclosure. As illustrated in the figure, the apparatus operating unit 130 may display or output text, an image, or a video including a plurality of defect scenarios 510, 520, 530 on the display screen. FIG. 5 assumes that a first defect scenario 510, a second defect scenario 520, and a third defect scenario 530 are displayed in specific areas on the display screen, but the present disclosure is not limited to the assumption; each text, image, or video may be displayed in any position on the display screen.

According to an embodiment, each defect scenario may include details and the level of difficulty of the defect scenario. For example, the first defect scenario 510 may be a sealing groove defect with a low level of difficulty, the second defect scenario 520 may be a sealing thickness defect having a deviation less than or equal to a reference value with a medium level of difficulty, and the third defect scenario 530 having a deviation greater than a reference value with a high level of difficulty. A user may select at least part of the plurality of defect scenarios 510, 520, 530 displayed on the display screen through a touch input to perform training based on the selected defect scenario.

Additionally or alternatively, one defect scenario among the plurality of defect scenarios 510, 520, 530 may be determined by a predetermined algorithm. For example, through a user account (or information related to the user account) of a user performing training, the simulation apparatus may determine a defect scenario for which the user is not fully skilled or a combination of defect scenarios. Here, the user's work skill level may be calculated or determined as a test result for each defect scenario, but the present disclosure is not limited to the specific scheme. Based on the configuration, the user may easily identify and process a defect scenario for which the user lacks training; thus, the user may be trained only in the defect scenario for which the user has low work skills.

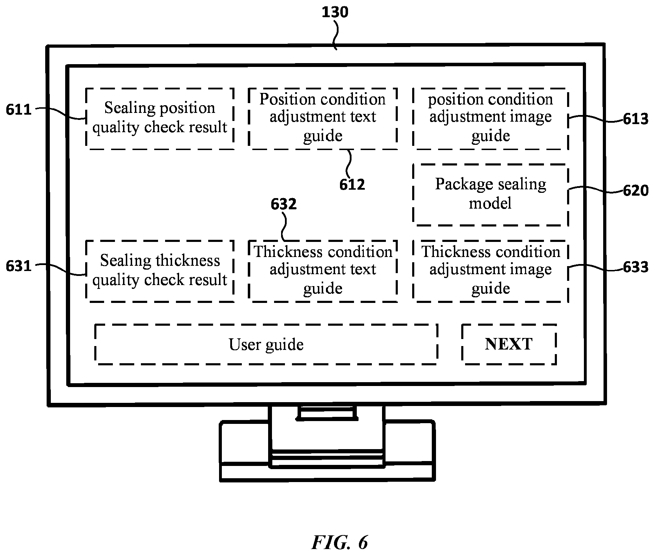

FIG. 6 illustrates an example of a display screen displayed or output on an apparatus operating unit 130 according to yet another embodiment of the present disclosure. As illustrated, the apparatus operating unit 130 may display or output, on the display screen, sealing position quality check result information 611 for identifying defects related to the sealing position, position condition adjustment text guide information 612 including condition information and action information required to solve the identified sealing position-related defects in text form; and position condition adjustment image guide information 613 including condition information and action information required to solve the identified sealing position-related defect in the form of an image. In addition, the apparatus operating unit 130 may display or output, on the display screen, sealing thickness quality check result information 631 for identifying defects related to the sealing thickness; thickness condition adjustment text guide information 632 including condition information and action information required to solve the identified sealing thickness-related defects in text form; and thickness condition adjustment image guide information 633 including condition information and action information required to solve the identified sealing thickness-related defect in the form of an image. In addition, the apparatus operating unit 130 may display or output, on the display screen, a package sealing model 620 that is a virtual realization of a package sealing apparatus for actual secondary battery production, and may display or output the position condition adjustment image guide 613 and thickness condition adjustment image guide 633 in connection with the package sealing model 620.

According to an embodiment, the sealing position quality check result may be output as good/defect depending on whether it is defective or not and the cause of the defects, and when the sealing position quality check result is defect, the position condition adjustment text guide information 612 and the position condition adjustment image guide information 613 may be output. In addition, the sealing thickness quality check result may be output as good/defect depending on whether it is defective or not and the cause of the defects, and when the sealing thickness quality check result is defect, the thickness condition adjustment text guide information 632 and the thickness condition adjustment image guide information 633 may be output.

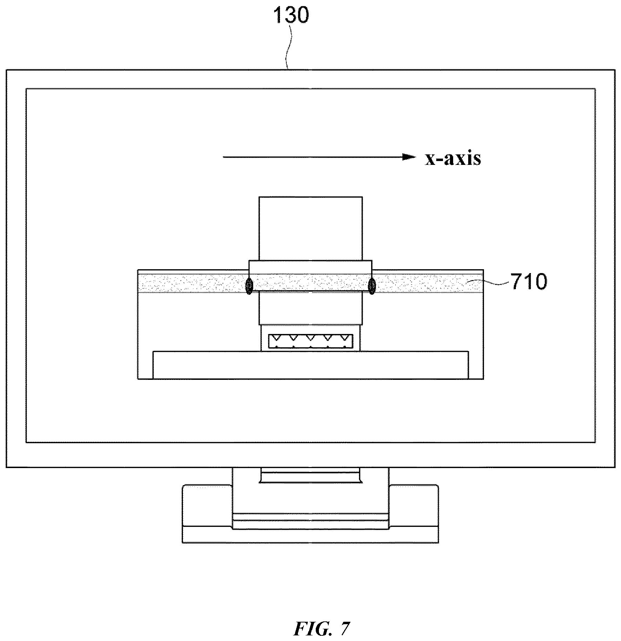

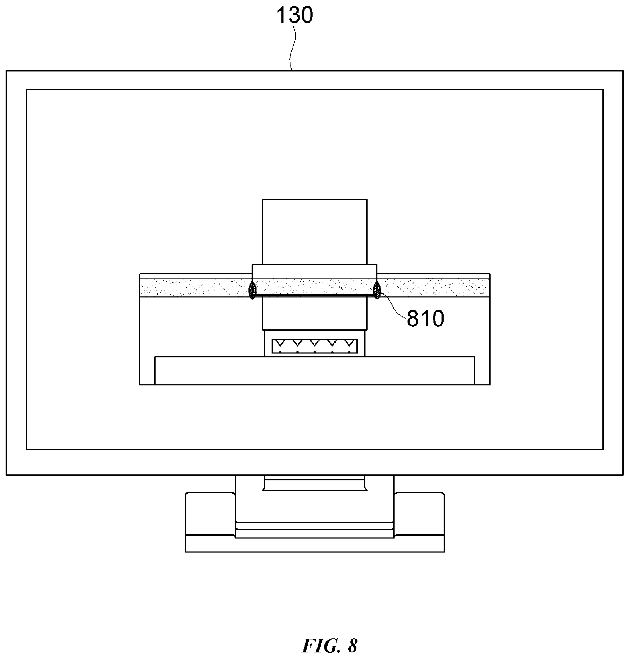

FIG. 7 illustrates an example of a sealing position of a cell in which a sealing groove defect scenario has occurred according to an embodiment of the present disclosure, and FIG. 8 illustrates an example of a sealing unit in which a sealing groove defect scenario has occurred according to an embodiment of the present disclosure.

The simulation apparatus (100 of FIG. 1) may determine one or more defect scenarios among a plurality of defect scenarios related to a malfunction of a 3D package apparatus and, based on the determined one or more defect scenarios, may change at least one of the operation of the 3D package apparatus or the quality information related to the quality of the material. Here, the plurality of defect scenarios may include a sealing groove defect scenario. For example, the sealing groove defect scenario may refer to a scenario in which an x-axis sealing position 710 of the material is out of an outer boundary or an inner boundary of a preset specification. That is, the sealing groove defect scenario may refer to a scenario in which a lower sealing unit of the sealing unit is out of a preset groove boundary 810.

According to an embodiment, when the determined one or more defect scenarios include the sealing groove defect scenario, images, videos, and animations such as dots, lines, and planes indicating the sealing position of the material produced by the 3D package apparatus included in the apparatus operating unit 130 may be changed to a predetermined area by the simulation apparatus.

In the case of such a sealing groove defect scenario, the apparatus operating unit 130 generates an alarm, and guides the user to check the quality and adjust a position of the lower sealing unit. The user may respond to the sealing groove defect scenario by touching or dragging a specific area of the 3D package apparatus displayed on the apparatus operating unit 130. In other words, the simulation apparatus may receive, from the user, user action information of touching or dragging at least part of the area corresponding to the quality check of the 3D package apparatus to determine the cause of the defect, and may receive, from the user, user action information of touching or dragging at least part of the area corresponding to the lower sealing unit to change the position of the lower sealing unit, thereby normally correcting the defective material.

Then, the simulation apparatus may determine whether the sealing groove defect scenario has been resolved based on at least partial area of the corrected material. For example, when the user action information is generated based on a touch input or a drag input to a predetermined area in a predetermined order, the simulation apparatus may determine that the sealing groove defect scenario has been resolved. In addition, when the user condition information is changed to a predetermined value, the simulation apparatus may determine that the sealing groove defect scenario has been resolved. If it is determined that the defect scenario has been resolved, the predetermined area indicating the sealing groove defect may be removed from the image, video and/or animation of the 3D package apparatus or material, and the quality parameter of the material displayed on the apparatus operating unit 130 may be corrected and changed normally.

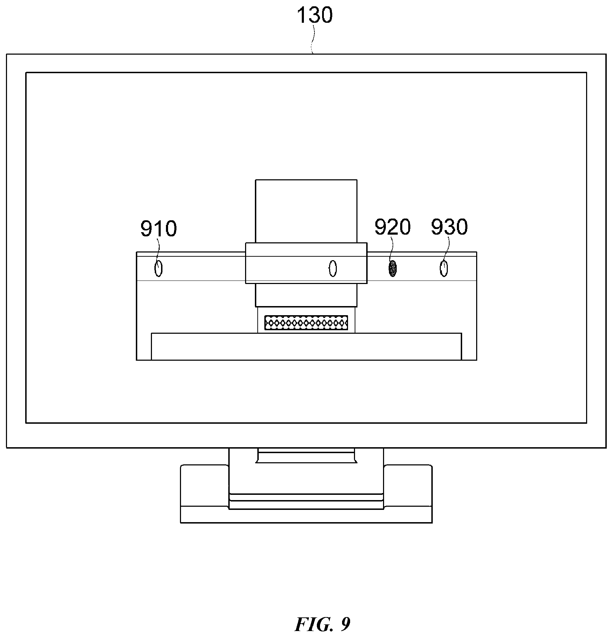

FIG. 9 illustrates an example in which a sealing thickness defect scenario in which a deviation is less than or equal to a reference value has occurred according to an embodiment of the present disclosure. The simulation apparatus (100 of FIG. 1) may determine one or more defect scenarios among a plurality of defect scenarios related to a malfunction of the 3D package apparatus and, based on the determined one or more defect scenarios, may change at least one of the operation of the 3D package apparatus or the quality information related to the quality of the material. Here, the plurality of defect scenarios may include a sealing thickness defect scenario in which a deviation is less than or equal to a reference value. For example, the sealing thickness defect scenario in which the deviation is less than or equal to a reference value may refer to a scenario in which a sealing thickness in at least one of a plurality of thickness measurement points 910, 920, 930 of a material is out of the upper limit or lower limit of the preset specification, and a deviation in sealing thickness between the measurement points is less than or equal to the preset reference value. According to an embodiment, when the determined one or more defect scenarios include the sealing thickness defect scenario in which the deviation is less than or equal to the reference value, images, videos, and animations such as dots, lines, and planes indicating the sealing thickness of the material produced by the 3D package apparatus included in the apparatus operating unit 130 may be changed to a predetermined area by the simulation apparatus.

In the case of such a sealing thickness defect scenario in which the deviation is less than or equal to the reference value, the apparatus operating unit 130 generates a sealing thickness defect alarm, and guides the user to check the quality and adjust an adjustment parameter (e.g., sealing temperature, sealing pressure, and contact time) related to the sealing thickness adjustment of the facility operating unit 120. The user may respond to the sealing thickness defect scenario in which the deviation is less than or equal to the reference value by touching or dragging a specific area of the 3D package apparatus displayed on the apparatus operating unit 130. In other words, the simulation apparatus may receive, from the user, user action information of touching or dragging at least part of the area corresponding to the quality check of the 3D package apparatus to determine the cause of the defect, and may receive, from the user, user action information of changing the adjustment parameter related to the sealing thickness adjustment to normally correct the defective material. For example, when the sealing thickness is less than the lower limit of the specification, the sealing thickness may be increased by decreasing the sealing temperature parameter setting value, decreasing the sealing pressure parameter setting value, or decreasing the contact time parameter setting value. In addition, when the sealing thickness is greater than the upper limit of the specification, the sealing thickness may be reduced by increasing the sealing temperature parameter setting value, increasing the sealing pressure parameter setting value, or increasing the contact time parameter setting value.

Then, the simulation apparatus may determine whether the sealing thickness defect scenario in which the deviation is less than or equal to the reference value has been resolved based on at least partial area of the corrected material. For example, when the user action information is generated based on a touch input or a drag input to a predetermined area in a predetermined order, the simulation apparatus may determine that the sealing thickness defect scenario has been resolved. In addition, when the user condition information is changed to a predetermined value, the simulation apparatus may determine that the sealing thickness defect scenario in which the deviation is less than or equal to the reference value has been resolved. If it is determined that the defect scenario has been resolved, the predetermined area indicating the sealing thickness defect may be removed from the image, video and/or animation of the 3D package apparatus or material, and the quality parameter of the material displayed on the apparatus operating unit 130 may be corrected and changed normally.

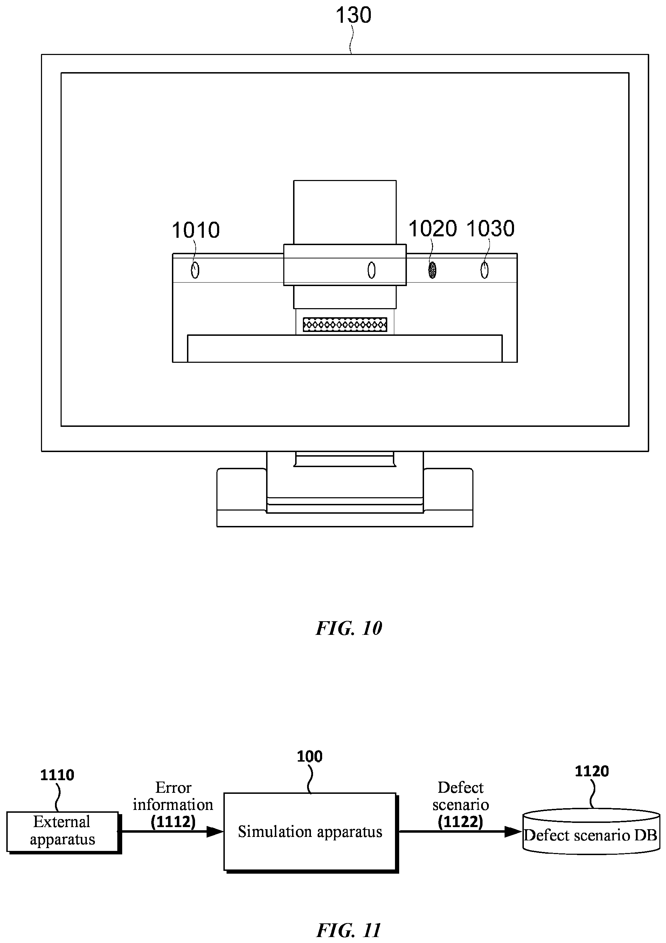

FIG. 10 illustrates an example in which a sealing thickness defect scenario in which a deviation is greater than a reference value has occurred according to an embodiment of the present disclosure. The simulation apparatus (100 of FIG. 1) may determine one or more defect scenarios among a plurality of defect scenarios related to a malfunction of the 3D package apparatus and, based on the determined one or more defect scenarios, may change at least one of the operation of the 3D package apparatus or the quality information related to the quality of the material. Here, the plurality of defect scenarios may include a sealing thickness defect scenario in which a deviation is greater than a reference value. For example, the sealing thickness defect scenario in which the deviation is greater than the reference value may refer to a scenario in which a sealing thickness in at least one of a plurality of thickness measurement points 1010, 1020, 1030 of a material is out of the upper limit or lower limit of the preset specification, and a deviation in sealing thickness between the measurement points of the main sealing is greater than the preset reference value. According to an embodiment, when the determined one or more defect scenarios include the sealing thickness defect scenario in which the deviation is greater than the reference value, images, videos, and animations such as dots, lines, and planes indicating the sealing thickness of the material produced by the 3D package apparatus included in the apparatus operating unit 130 may be changed to a predetermined area by the simulation apparatus.

In the case of such a sealing thickness defect scenario in which the deviation is greater than the reference value, the apparatus operating unit 130 generates a sealing thickness defect alarm, and guides the user to check the quality and clean the sealing tool. The user may respond to the sealing thickness defect scenario by touching or dragging a specific area of the 3D package apparatus displayed on the apparatus operating unit 130. In other words, the simulation apparatus may receive, from the user, user action information of touching or dragging at least part of the area corresponding to the quality check of the 3D package apparatus to determine the cause of the defect, and may receive, from the user, user action information of touching or dragging at least partial area corresponding to the sealing tool to remove contaminants attached to the sealing tool, thereby normally correcting the defective material. Then, the simulation apparatus may determine whether the sealing thickness defect scenario in which the deviation is greater than the reference value has been resolved based on at least partial area of the corrected material. For example, when the user action information is generated based on a touch input or a drag input to a predetermined area in a predetermined order, the simulation apparatus may determine that the sealing thickness defect scenario has been resolved. In addition, when the user condition information is changed to a predetermined value, the simulation apparatus may determine that the sealing thickness defect scenario has been resolved. If it is determined that the defect scenario has been resolved, the predetermined area indicating the sealing thickness defect may be removed from the image, video and/or animation of the 3D package apparatus or material, and the quality parameter of the material displayed on the apparatus operating unit 130 may be corrected and changed normally.

However, if the material is not normally corrected even after cleaning the sealing tool, the simulation apparatus guides the user to check the quality and perform at least one of adjusting a height of a sealing tool stopper or inserting/removing a feeler gauge in the facility operating unit 120. The simulation apparatus may receive, from the user, user action information of touching or dragging at least part of the area corresponding to the quality check of the 3D package apparatus to determine the cause of the defect, and may receive, from the user, user action information of touching or dragging at least partial area of at least one of the sealing tool stopper or the feeler gauge to adjust a height of the sealing tool stopper and insert or remove the feeler gauge, thereby normally correcting the defective material.

For example, if the sealing thickness on one side of left- or right-side measurement points is smaller than the lower limit of the specification, the sealing thickness on one side may be increased by adding a shim ring to the sealing tool stopper on one side or removing the feeler gauge from the sealing tool on one side. In addition, if the sealing thickness on one side of the left- or right-side measurement points is greater than the upper limit of the specification, the sealing thickness on one side may be reduced by removing a shim ring from the sealing tool stopper on one side or inserting the feeler gauge to the sealing tool on one side. In addition, if a deviation between a sealing thickness at a center measurement point and sealing thicknesses on opposite side measurement points is large, the sealing thickness may be corrected by reducing the deviation between the center measurement point and the opposite side measurement points through adding or removing a shim ring or removing or inserting a feeler gauge to or from the sealing tool stoppers on opposite sides. Then, the simulation apparatus may determine whether the sealing thickness defect scenario has been resolved based on at least partial area of the corrected material. For example, when the user action information is generated based on a touch input or a drag input to a predetermined area in a predetermined order, the simulation apparatus may determine that the sealing thickness defect scenario has been resolved. In addition, when the user condition information is changed to a predetermined value, the simulation apparatus may determine that the sealing thickness defect scenario has been resolved. If it is determined that the defect scenario has been resolved, the predetermined area indicating the sealing thickness defect may be removed from the image, video and/or animation of the 3D package apparatus or material, and the quality parameter of the material displayed on the apparatus operating unit 130 may be corrected and changed normally.

Although it is illustrated in FIGS. 7 to 10 that an image, a video, and/or an animation indicating part of the 3D package apparatus is displayed on the apparatus operating unit 130, but the present disclosure is not limited thereto, and the apparatus operating unit 130 may include images, videos and/or animations of the same shape as the actual package apparatus. With such a configuration, the user may effectively learn in advance how to respond to problems that may occur in the package process, and the simulation apparatus may effectively determine whether the problem has been solved based on the input or received user actions.

It is illustrated in FIGS. 7 to 10 that there may be the sealing groove defect scenario, the sealing thickness defect scenario in which the deviation is less than or equal to the reference value, the sealing thickness defect scenario in which the deviation is greater than the reference value, and the like, but the plurality of defect scenarios may further include other defect scenarios that may occur in the package apparatus.

It is illustrated in FIGS. 7 to 10 that the sealing groove defect scenario, the sealing thickness defect scenario in which the deviation is less than or equal to the reference value, and the sealing thickness defect scenario in which the deviation is greater than the reference value may each individually occur; however, the present disclosure is not limited thereto, and two or more defect scenarios may occur in combination.

FIG. 11 illustrates an example in which a defect scenario 1122 is generated according to an embodiment of the present disclosure. As illustrated in the figure, the simulation apparatus 100 may communicate with an external device (e.g., secondary battery production equipment) 1110 and a defect scenario DB 1120 and exchange data and/or information required for generating the defect scenario 1122.

According to an embodiment, when a malfunction occurs in an external device 1110, the simulation apparatus 100 may receive or obtain error information 1112 related to the malfunction from the external device 1110. Here, the error information 1112 may include operation information of the external device 1110 when the malfunction occurs and the quality change level of a material produced by the external device 1110. In this case, the simulation apparatus 100 may determine condition values and setting values of a 3D model apparatus (e.g., a 3D package apparatus) and/or each quality parameter value of the quality information and generate a defect scenario 1122 having the condition values and the setting values of the determined 3D model apparatus and/or the quality parameter values to respond to the corresponding error information 1112. The generated defect scenario 1122 may be stored and managed in the defect scenario DB 1120. For example, the simulation apparatus 100 may determine condition values and setting values of a 3D model apparatus and/or each quality parameter value of the quality information and generate a defect scenario 1122 to respond to the error information 1112 by using an arbitrary algorithm for generating a defect scenario 1122 and/or a trained machine learning model.

According to an embodiment, the processor may convert the operation information of the external device 1110 into a first set of parameters related to the operation of the 3D model apparatus and convert the quality change level of a material produced by the external device 1110 into a second set of parameters related to the quality information related to the quality of a material produced by the 3D model apparatus. Then, the processor may determine the category of a malfunction occurring in the external device 1110 using the converted first set of parameters and second set of parameters and generate a defect scenario based on the determined category, the first set of parameters, and the second set of parameters.

FIG. 11 assumes that a defect scenario occurs when a malfunction occurs in the external apparatus 1110, but the present disclosure is not limited to the assumption; for example, a defect scenario may be predetermined by an arbitrary user. In another example, a defect scenario may be generated by randomly determining setting values, condition values, and quality information related to the 3D model apparatus within a predetermined, abnormal range. Based on the configuration above, a user may be trained using a defect scenario generated based on a malfunction occurring in actual work environments, thereby effectively improving the ability to respond to defects.

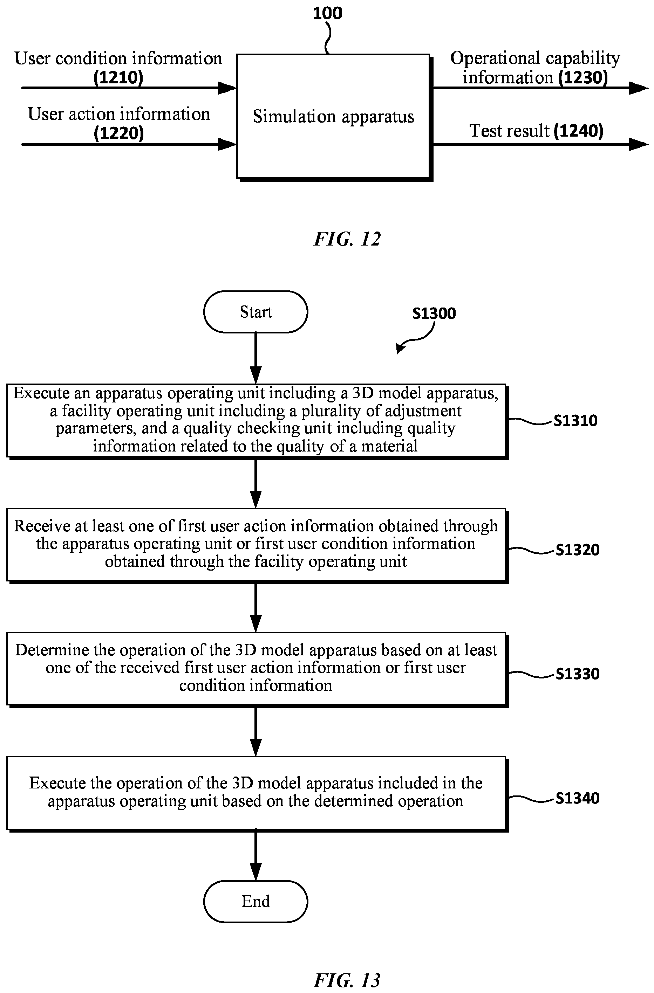

FIG. 12 illustrates an example in which operational capability information 1230 and a test result 1240 are generated according to an embodiment of the present disclosure. As described above, when a defect scenario occurs, the simulation apparatus 100 may receive user condition information 1210 and user action information 1220 from a user and, based on the received user condition information 1210 and user action information 1220, determine whether the defect scenario has been resolved.

According to an embodiment, when it is determined that a defect scenario has been resolved, the simulation apparatus 100 may calculate a progress time and a loss value of the defect scenario while the defect scenario is in progress and, based on the calculated progress time and loss value, generate the operational capability information 1230 for the 3D model apparatus of a user account. In this case, a test result 1240 may be output together with the operational capability information 1230. For example, a user related to the corresponding user account may take a test for an arbitrary defect scenario, and when all defect scenarios related to a specific 3D model apparatus are resolved according to a predetermined criterion, the simulation apparatus 100 may determine that the corresponding user has passed a simulation test for the specific 3D model apparatus.

FIG. 13 illustrates an example of a simulation method S1300 for secondary battery production according to an embodiment of the present disclosure. The simulation method S1300 for secondary battery production may be performed by a processor (e.g., at least one processor of a simulation apparatus). As illustrated in the figure, the simulation method S1300 for secondary battery production may be initiated as the processor executes an apparatus operating unit including a 3D model apparatus related to secondary battery production, a facility operating unit including a plurality of adjustment parameters for determining the operation of the 3D model apparatus, and a quality checking unit including quality information related to the quality of a material produced by the 3D model apparatus S1310.

The processor may obtain at least one of first user action information obtained through the apparatus operating unit or first user condition information obtained through the facility operating unit S 1320. Here, the first user condition information may include information related to a value corresponding to at least one adjustment parameter among a plurality of adjustment parameters.

The processor may determine the operation of the 3D model apparatus based on at least one of the first user action information or the first user condition information obtained S1330. In addition, the processor may execute the operation of the 3D model apparatus included in the apparatus operating unit based on the determined operation S1340. When receiving the first user action information, the processor may determine whether the received first user action information corresponds to a predetermined operating condition of the 3D model apparatus and approve the operation of the 3D model apparatus when it is determined that the first user action information corresponds to the predetermined operating condition of the 3D model apparatus.

According to an embodiment, the processor may determine one or more quality parameters for determining the quality of a material produced by the 3D model apparatus and, while the operation of the 3D model apparatus is executed, calculate a value corresponding to each of the determined one or more quality parameters based on the operation of the 3D model apparatus in execution. In addition, the processor may generate quality information related to the quality of a material produced by the 3D model apparatus based on the calculated value corresponding to each of the one or more quality parameters.

According to an embodiment, the processor may determine one or more defect scenarios among a plurality of defect scenarios related to a malfunction of the 3D model apparatus and change at least one of the 3D model apparatus's operation or quality information related to the quality of a material based on the determined one or more defect scenarios. Then, the processor may receive at least one of second user action information or second user condition information for resolving the determined one or more defect scenarios and, based on at least one of the received second user action information or second user condition information, correct the changed operation of the 3D model apparatus. In addition, while the corrected operation of the 3D model apparatus is executed, the processor may calculate a value corresponding to each of a plurality of quality parameters related to the quality of a material produced by the 3D model apparatus based on the operation of the 3D model apparatus in execution. In this case, the processor may correct the quality information related to the quality of a material produced by the corrected 3D model apparatus based on the calculated value corresponding to each of the plurality of quality parameters and, by using the corrected quality information, determine whether one or more defect scenarios have been resolved.

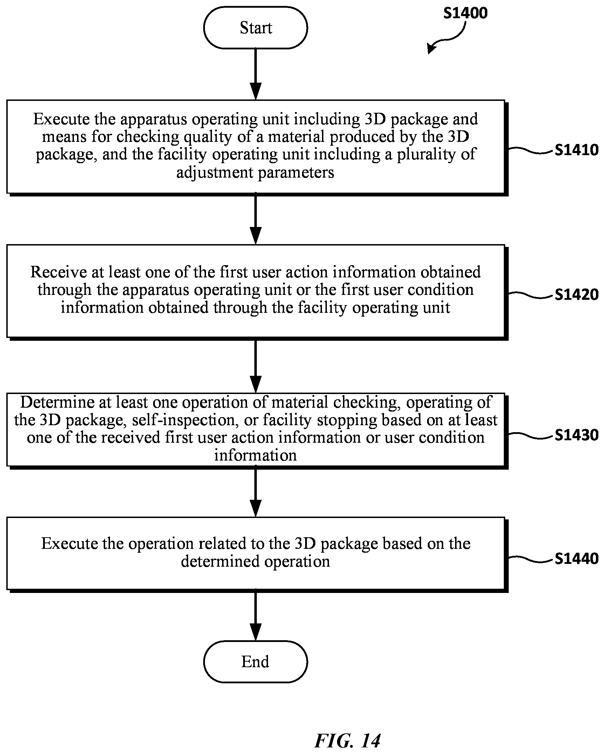

FIG. 14 illustrates an example of a simulation method S1400 of a package apparatus for secondary battery production according to an embodiment of the present disclosure. The simulation method S1400 of package for secondary battery production may be performed by a processor (e.g., at least one processor of a simulation apparatus). As illustrated in the figure, the simulation method S1400 of a package for secondary battery production may be initiated as the processor executes the apparatus operating unit including a 3D package related to the production of secondary batteries and a means for checking the quality of a material produced by the 3D package, and the facility operating unit including a plurality of adjustment parameters for determining the operation of the 3D package S1410.

The processor may obtain at least one of first user action information obtained through the apparatus operating unit or first user condition information obtained through the facility operating unit S1420. In addition, the processor may determine at least one operation of a material checking, an operation of the 3D package apparatus, a self-inspection, and a facility stop based on at least one of the obtained first user action information or first user condition information S1430. In addition, the processor may execute the operation related to the 3D package based on the determined operation S1440. The material checking operation may include operations of checking materials required for package, such as a lead, an Al pouch, an insulation tape, and the like. In addition, the operation of operating the 3D package apparatus may include operations such as loading, tab welding, Al forming, Cell Assy, EL filling, V-sealing, unloading and the like. In addition, the self-inspection operation may include operations such as inspection of a welding tensile strength, inspection of a tab condition, inspection of a tab position, inspection of a lead film protruding position, inspection of a lead center, inspection of a sealing position, inspection of a sealing thickness, inspection of a terrace width, inspection of a cup sealing gap, and the like.

According to an embodiment, the processor may change the adjustment parameter displayed on the facility operating unit based on the first user action information. In addition, when the processor receives the first user action information and the first user condition information, and it is determined that the received first user action information and the first user condition information correspond to a predetermined user action and user condition input, the process may permit operation of the 3D package.

In addition, the processor may determine one or more quality parameters for determining the quality of a material produced by the 3D package and, while the operation of the 3D package is executed, calculate a value corresponding to each of the determined one or more quality parameters based on the operation of the 3D package in execution. In addition, the processor may generate quality information related to the quality of a material produced by the 3D package based on the calculated value corresponding to each of the one or more quality parameters.

According to an embodiment, the processor may determine one or more defect scenarios among a plurality of defect scenarios related to a malfunction of the 3D package and change at least one of the 3D package's operation or quality information related to the quality of a material based on the determined one or more defect scenarios. For example, the plurality of defect scenarios may include a sealing groove defect scenario, a sealing thickness defect scenario in which the deviation is less than or equal to the reference value, and a sealing thickness defect scenario in which the deviation is greater than the reference value, and the like. In this case, each defect scenario may be resolved by arbitrary user condition information and user action information input from a user.

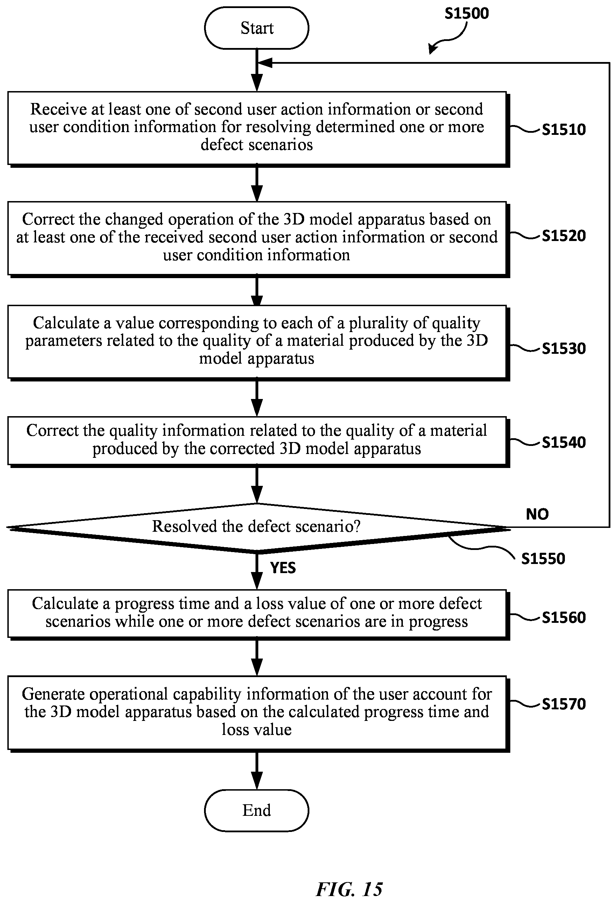

FIG. 15 illustrates an example of a method of calculating a test result S1500 according to an embodiment of the present disclosure. The method of calculating a test result S1500 may be performed by a processor (e.g., at least one processor of a simulation apparatus). As illustrated in the figure, the method of calculating a test result S1500 may be initiated as the processor receives at least one of second user action information or second user condition information for resolving determined one or more defect scenarios S1510.

As described above, the processor may correct the changed operation of the 3D model apparatus based on at least one of the received second user action information or second user condition information S1520. In addition, while the corrected operation of the 3D model apparatus is executed, the processor may calculate a value corresponding to each of a plurality of quality parameters related to the quality of a material produced by the 3D model apparatus based on the operation of the 3D model apparatus in execution S1530. In this case, the processor may correct the quality information related to the quality of a material produced by the corrected 3D model apparatus based on the calculated value corresponding to each of the plurality of quality parameters S1540.

Then, the processor may determine whether one or more defect scenarios have been resolved using the corrected quality information and/or the setting values and condition values of the 3D model apparatus S1550. When it is determined that the defect scenario has not been resolved, the processor may again generate or obtain the second user action information and the second user condition information using the information input by the user.

When it is determined that one or more defect scenarios have been resolved, the processor may calculate a progress time and a loss value of one or more defect scenarios while one or more defect scenarios are in progress S1560. In addition, based on the calculated progress time and loss value, the processor may generate operational capability information of the user account for the 3D model apparatus S1570. Here, the operational capability information may include, but is not limited to, a progress speed and accuracy calculated using a progress time and a loss value, and may further include the user's test score and whether the user has passed the test. In this case, one user account may be assigned to each user performing secondary battery production; the operational capability information generated based on the user's progress time for a defect scenario and a loss value may be stored or managed in conjunction with the user account.

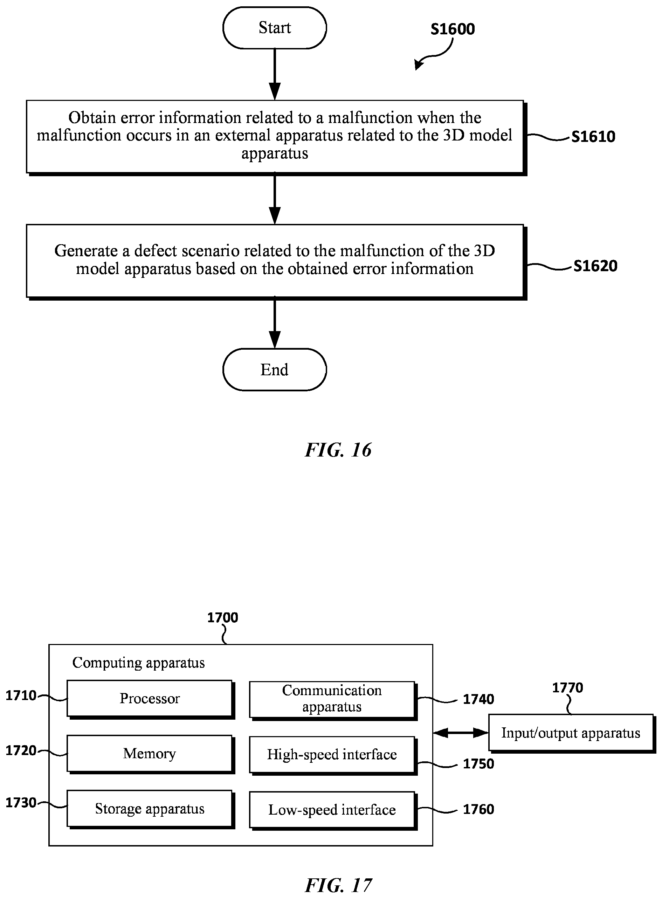

FIG. 16 illustrates an example of a method of generating a defect scenario S1600 according to an embodiment of the present disclosure. The method of generating a defect scenario S1600 may be performed by a processor (e.g., at least one processor of a simulation apparatus). As illustrated in the figure, the method of generating a defect scenario S1600 may be initiated as the processor obtains error information related to a malfunction when the malfunction occurs in an external apparatus related to the 3D model apparatus S1610.

The processor may generate a defect scenario related to a malfunction of the 3D model apparatus based on the obtained error information S1620. Here, the error information may include each adjustment parameter value and setting values of actual secondary battery production equipment related to the 3D model apparatus, obtained when the corresponding production equipment malfunctions. For example, when the quality of a material produced by secondary battery production equipment gets out of a predetermined normal range, it may be determined that a malfunction has occurred; when it is determined that a malfunction has occurred, the processor may obtain error information related to the malfunction and generate a defect scenario related to the malfunction of the 3D model apparatus based on the obtained error information.

FIG. 17 illustrates an exemplary computing device 1700 for performing the method and/or embodiments. According to an embodiment, the computing device 1700 may be implemented using hardware and/or software configured to interact with a user. Here, the computing device 1700 may include the simulation apparatus (100 of FIG. 1). For example, the computing device 1700 may be configured to support virtual reality (VR), augmented reality (AR), or mixed reality (MR) environments but is not limited thereto. The computing device 1700 may include a laptop computer, a desktop computer, a workstation, a personal digital assistant, a server, a blade server, and a mainframe computer, which is not limited thereto. The constituting elements of the computing device 1700 and connection relationships and functions of the constituting elements are intended to be illustrative and not intended to limit the implementations of the present disclosure described and/or claimed herein.

The computing device 1700 includes a processor 1710, a memory 1720, a storage device 1730, a communication device 1740, a high-speed interface 1750 connected to the memory 1720 and a high-speed expansion port, and a low-speed interface 1760 connected to a low-speed bus and a low-speed storage device. Each of the constituting elements 1710, 1720, 1730, 1740, 1750, 1760 may be interconnected using a variety of buses, mounted on the same main board, or mounted and connected in other suitable ways. The processor 1710 may be configured to process instructions of a computer program by performing basic arithmetic, logic, and input/output operations. For example, the processor 1710 may process instructions stored in the memory 1720 and the storage device 1730 and/or instructions executed within the computing device 1700 and display graphic information on an external input/output device 1770 such as a display device combined with the high-speed interface 1750.

The communication device 1740 may provide a configuration or a function for the input/output device 1770 and the computing device 1700 to communicate with each other through a network and provide a configuration or a function to support the input/output device 1770 and/or the computing device 1700 to communicate with another external apparatus. For example, a request or data generated by the processor of the external apparatus according to an arbitrary program code may be transmitted to the computing device 1700 through a network under the control of the communication device 1740. Conversely, a control signal or a command provided under the control of the processor 1710 of the computing device 1700 may be transmitted to another external device through the communication device 1740 and a network.

FIG. 17 assumes that the computing device 1700 includes one processor 1710 and one memory 1720, but the present disclosure is not limited to the assumption; the computing device 1700 may be implemented using a plurality of memories, a plurality of processors, and/or a plurality of buses. In addition, although FIG. 17 assumes that one computing device 1700 is employed, the present disclosure is not limited to the assumption, and a plurality of computing devices may interact with each other and perform operations required to execute the method described above.

The memory 1720 may store information in the computing device 1700. According to an embodiment, the memory 1720 may include a volatile memory unit or a plurality of memory units. Additionally or alternatively, the memory 1720 may be composed of a non-volatile memory unit or a plurality of memory units. In addition, the memory 1720 may be implemented using a different type of computer-readable medium, such as a magnetic disc or an optical disc. In addition, an operating system and at least one program code and/or instruction may be stored in the memory 1720.

The storage device 1730 may be one or more mass storage devices for storing data for the computing device 1700. For example, the storage device 1730 may be configured to include a hard disc; a magnetic disc such as a portable disc; an optical disc; a semiconductor memory device such as an erasable programmable read-only memory (EPROM), an electrically erasable PROM (EEPROM), and a flash memory; and a computer-readable medium including a CD-ROM or DVD-ROM disc; or the storage device 1730 may be configured to include the computer-readable medium. In addition, the computer program may be implemented tangibly in the computer-readable medium.

The high-speed interface 1750 and the low-speed interface 1760 may be used for interaction with the input/output device 1770. For example, an input device may include a camera including an audio sensor and/or an image sensor, a keyboard, a microphone, and a mouse; an output device may include a display, a speaker, and a haptic feedback device. In another example, the high-speed interface 1750 and the low-speed interface 1760 may be used for interfacing with a device in which a configuration or function for performing input and output operations is integrated into one entity, such as a touch screen.

According to an embodiment, the high-speed interface 1750 manages bandwidth-intensive operations for the computing device 1700, while the low-speed interface 1760 manages less bandwidth-intensive operations than the high-speed interface 1750, where the above functional assignment has been made merely for an illustrative purpose. According to an embodiment, the high-speed interface 1750 may be coupled to high-speed expansion ports capable of accommodating the memory 1720, the input/output device, and various expansion cards (not shown). In addition, the low-speed interface 1760 may be coupled to the storage device 1730 and low-speed expansion ports. Additionally, the low-speed expansion port, which may include various communication ports (e.g., USB, Bluetooth, Ethernet, and wireless Ethernet), may be coupled to one or more input/output devices 1770, such as a keyboard, a pointing device, and a scanner, or a networking device, such as a router or a switch, through a network adaptor.

The computing device 1700 may be implemented in many different forms. For example, the computing device 1700 may be implemented as a standard server or a group of standard servers. Additionally or alternatively, the computing device 1700 may be implemented as part of a rack server system or may be implemented as a personal computer, such as a laptop computer. In this case, constituting elements from the computing device 1700 may be combined with other constituting elements of an arbitrary mobile device (not shown). The computing device 1700 may include one or more other computing devices or may be configured to communicate with one or more computing devices.

FIG. 17 assumes that the input/output device 1770 is not included in the computing device 1700, but the present disclosure is not limited to the assumption; the input/output device 1770 may be configured to be integrated into the computing device 1700 to form a single device. In addition, FIG. 17 illustrates that the high-speed interface 1750 and/or the low-speed interface 1760 are illustrated as being configured separately from the processor 1710; however, the present disclosure is not limited thereto, and the high-speed interface 1750 and/or the low-speed interface 1760 may be configured to be included in the processor 1710.

The method and/or various embodiments described above may be implemented in digital electronic circuitry, computer hardware, firmware, software, and/or a combination thereof. Various embodiments of the present disclosure may be executed by a data processing device, for example, one or more programmable processors and/or one or more computing devices; or implemented as a computer-readable medium and/or a computer program stored on a computer-readable medium. The computer program may be written in any form of programming language including a compiled language or an interpreted language and may be distributed in any form such as a stand-alone program, a module, or a subroutine. The computer program may be distributed via a plurality of computing devices connected through one computing device and the same network and/or a plurality of distributed computing devices connected through a plurality of different networks.

The method and/or various embodiments described above may be performed by one or more processors configured to execute one or more computer programs that process, store, and/or manage arbitrary functions by operating based on input data or generating output data. For example, the method and/or various embodiments of the present disclosure may be performed by a special-purpose logic circuit such as a Field Programmable Gate Array (FPGA) or an Application Specific Integrated Circuit (ASIC); an apparatus and/or a system for performing the method and/or various embodiments of the present disclosure may be implemented as a special-purpose logic circuit such as an FPGA or an ASIC.

The one or more processors executing the computer program may include a general-purpose or special-purpose microprocessor and/or one or more processors of an arbitrary type of digital computing device. The processor may receive instructions and/or data from each of the read-only memory and the random-access memory or may receive instructions and/or data from the read-only memory and the random-access memory. In the present disclosure, the constituting elements of a computing device performing the method and/or embodiments may include one or more processors for executing instructions; and one or more memories for storing instructions and/or data.

According to an embodiment, the computing device may send and receive data to and from one or more mass storage devices for storing data. For example, the computing device may receive data from a magnetic or optical disc and transmit data to the magnetic or optical disc. A computer-readable medium suitable for storing instructions and/or data related to a computer program may include any form of non-volatile memory including a semiconductor memory device such as an Erasable Programmable Read-Only Memory (EPROM), an Electrically Erasable PROM (EEPROM), and a flash memory device; however, the present disclosure is not limited thereto. For example, a computer-readable medium may include a magnetic disc such as an internal hard disc or a removable disc, a photomagnetic disk, a CD-ROM disc, and a DVD-ROM disc.

To provide interaction with a user, the computing device may include a display device (e.g., a cathode ray tube (CRT) or a liquid crystal display (LCD)) for providing or displaying information to the user and a pointing device (e.g., a keyboard, a mouse, or a trackball) through which the user may provide input and/or commands to the computing device by the user; however, the present disclosure is not limited to the specific example above. In other words, the computing device may further include any other kind of device for providing interaction with the user. For example, the computing device may provide any form of sensory feedback to the user for interaction with the user, including visual feedback, auditory feedback, and/or tactile feedback. In response to the feedback, the user may provide input to the computing device through various gestures including a visual expression, voice, and motion.

In the present disclosure, various embodiments may be implemented in a computing device that includes a back-end component (e.g., a data server), a middleware component (e.g., an application server), and/or a front-end component. In this case, the constituting elements may be interconnected by any form or any medium of digital data communication, such as a communication network. According to an embodiment, the communication network includes a wired network such as Ethernet, a wired home network (Power Line Communication), a telephone line communication device, and RS-serial communication; a wireless network such as a mobile communication network, a wireless LAN (WLAN), Wi-Fi, and Bluetooth; or a combination of the wired and wireless networks. For example, the communication network may include a local area network (LAN) and a wide area network (WAN).

A computing device based on the illustrative embodiments described herein may be implemented using hardware and/or software configured to interact with a user, including a user device, a user interface (UI) device, a user terminal, or a client device. For example, the computing device may include a portable computing device such as a laptop computer. Additionally or alternatively, the computing device may include a Personal Digital Assistants (PDA), a tablet PC, a game console, a wearable device, an Internet of Things (IoT) device, a virtual reality (VR) device, and an augmented reality (AR) device but is not limited thereto. The computing device may further include other types of devices configured to interact with the user. In addition, the computing device may include a portable communication device (e.g., a mobile phone, a smartphone, or a wireless cellular phone) suitable for wireless communication over a network, such as a mobile communication network. The computing device may be configured to communicate wirelessly with a network server using wireless communication technologies and/or protocols such as Radio Frequency (RF), Microwave Frequency (MWF), and/or Infrared Ray Frequency (IRF).

Various embodiments of the present disclosure, including specific structural and functional details, are illustrative in nature. Accordingly, the embodiments of the present disclosure are not limited to those described above and may be implemented in various other forms. **In** addition, the terms used in the present disclosure are intended for describing part of embodiments and should not be construed as limiting the embodiments. For example, singular words and the descriptions above may be construed to include plural forms unless the context dictates otherwise.

Unless defined otherwise, terms used in the present disclosure, including technical or scientific terms, may convey the same meaning understood generally by those skilled in the art to which the present disclosure belongs. Among the terms used in the present disclosure, commonly used terms, such as those defined in ordinary dictionaries, should be interpreted to convey the same meaning in the context of related technology.

## Claims

1. A package simulation apparatus for secondary battery production, the simulation apparatus (100) comprising:
a) a memory (1720) configured to store at least one instruction; and
b) at least one processor (1710) configured to execute the at least one instruction stored in the memory (1720) to perform operations comprising:
b1) executing (S1310, S1410) an apparatus operating unit (130, 210) comprising a 3D package apparatus related to secondary battery production, wherein the apparatus operating unit (130, 210) is a software module apparatus operating unit (130, 210) and the 3D package apparatus is a virtual 3D package apparatus;
b2) checking (S1310, S1410) quality of a material produced by the 3D package apparatus;
b3) executing (S1310, S1410) a facility operating unit (120) comprising a plurality of adjustment parameters for determining an operation of the 3D package apparatus, wherein the facility operating unit (120) is a software module facility operating unit (120);
b4) obtaining (S1320, S1420) at least one of first user action information obtained through the apparatus operating unit (130, 210) or first user condition information obtained through the facility operating unit (120);
b5) determining (S1330, S1430) at least one of a material checking, the operation of the 3D package apparatus, or a self-inspection based on at least one of the first user action information or the first user condition information;
b6) generating a defect scenario (1122) based on error information (1112) from an actual apparatus (1110); and
b7) executing (S1340, S1440) the operation of the 3D package apparatus.

2. The apparatus (100) of claim 1, wherein the material checking includes checking at least one of a lead, an aluminum pouch, or an insulating tape.

3. The apparatus (100) of claim 1 or 2, wherein the operations further include performing at least one of tab welding, aluminum pouch forming, cell insertion, electrolyte filling, or V-sealing.

4. The apparatus (100) of any one of claims 1 to 3, wherein the operations further include inspecting at least one of a welding tensile strength, a tab condition, a tab position, a lead film protruding position, a lead center, a sealing position (710), a sealing thickness, a terrace width, or a cup sealing gap.

5. The apparatus (100) of any one of claims 1 to 4, wherein the operations further include:
determining one or more quality parameters for determining the quality of the material produced by the 3D package apparatus;
calculating (S1530) a value corresponding to the one or more quality parameters based on the operation of the 3D package apparatus; and
outputting quality information related to the quality of the material produced by the 3D package apparatus based on the value corresponding to the one or more quality parameters.

6. The apparatus (100) of any one of claims 1 to 4, wherein the operations further include:
determining (S1620) one or more defect scenarios (510, 520, 530) related to the quality of the material produced by the 3D package apparatus; and
changing at least one of the operation of the 3D package apparatus or quality information related to the quality of the material based on the one or more defect scenarios (510, 520, 530).

7. The apparatus (100) of claim 6, wherein the one or more defect scenarios (510, 520, 530) include at least one of a sealing groove defect scenario in which an x-axis groove position of the material is out of a boundary (810) of a preset specification, a first sealing thickness defect scenario in which a sealing thickness in at least one measurement point among a plurality of measurement points (910, 920, 930, 1010, 1020, 1030) of the material is out of an upper limit or a lower limit of the preset specification and a deviation in sealing thicknesses between the plurality of measurement points (910, 920, 930, 1010, 1020, 1030) is less than or equal to a preset reference value, or a second sealing thickness defect scenario in which the sealing thickness in the at least one measurement point among the plurality of measurement points (910, 920, 930, 1010, 1020, 1030) of the material is out of the upper limit or the lower limit of the preset specification and the deviation in sealing thicknesses between the plurality of measurement points (910, 920, 930, 1010, 1020, 1030) is greater than the preset reference value.

8. The apparatus (100) of claim 7, wherein the operations further include:
executing at least one of the sealing groove defect scenario, the first sealing thickness defect scenario, or the second sealing thickness defect scenario;
obtaining (S1510) at least one of second user action information of touching or dragging at least part of an area of the 3D package apparatus or second user condition information of changing one of the plurality adjustment parameters of the facility operating unit (120);
correcting (S1520) the 3D package apparatus based on at least one of the second user action information or the second user condition information;
calculating (S1530) a value corresponding to one or more quality parameters related to quality of the material produced by the corrected 3D package apparatus; and
correcting (S1540) quality information related to the quality of the material produced by a corrected 3D package apparatus based on the value corresponding to the one or more quality parameters.

9. The apparatus (100) of claim 7 or 8, wherein the operations further include:
obtaining third user action information of touching or dragging at least part of an area corresponding to a quality check of the material produced by the 3D package apparatus; and
outputting a defect cause of the material based on the third user action information.

10. The apparatus (100) of any one of claims 7 to 9, wherein the operations further include outputting guide information including condition information and action information related to resolving the one or more defect scenarios (510, 520, 530).

11. A package simulation method for secondary battery production, the method executed by at least one processor, the method comprising:
a) executing (S1310, S1410) an apparatus operating unit (130, 210) comprising a 3D package apparatus related to secondary battery production, wherein the apparatus operating unit (130, 210) is a software module apparatus operating unit (130, 210) and the 3D package apparatus is a virtual 3D package apparatus;
b) checking (S1310, S1410) quality of a material produced by the 3D package apparatus;
c) executing (S1310, S1410) a facility operating unit (120) comprising a plurality of adjustment parameters for determining an operation of the 3D package apparatus, wherein the facility operating unit (120) is a software module facility operating unit (120);
d) obtaining (S1320, S1420) at least one of first user action information obtained through the apparatus operating unit (130, 210) or first user condition information obtained through the facility operating unit (120);
e) determining (S1330, S1430) at least one of a material checking, the operation of the 3D package apparatus, or a self-inspection based on at least one of the first user action information or the first user condition information;
f) generating a defect scenario (1122) based on error information (1112) from an actual apparatus (1110); and
g) executing (S1340, S1440) the operation of the 3D package apparatus.

12. The method of claim 11, wherein when the determined operation is the material checking, the executing of the determined operation comprises checking at least one of a lead, an aluminum pouch, or an insulating tape.

13. The method of claim 11 or 12, wherein when the determined operation is the operation of the 3D package apparatus, the executing of the determined operation comprises operating at least one of tab welding, aluminum pouch forming, cell insertion, electrolyte filling, or V-sealing.

14. The method of any one of claims 11 to 13, wherein when the determined operation is the self-inspection, the executing of the determined operation comprises inspecting at least one of a welding tensile strength, a tab condition, a tab position, a lead film protruding position, a lead center, a sealing position (710), a sealing thickness, a terrace width, or a cup sealing gap.

15. The method of any one of claims 11 to 14, further comprising:
determining one or more quality parameters for determining the quality of the material produced by the 3D package apparatus;
calculating (S1530) a value corresponding to the one or more quality parameters based on the operation of the 3D package apparatus; and
outputting quality information related to the quality of the material produced by the 3D package apparatus based on the value corresponding to the one or more quality parameters.

16. The method of any one of claims 11 to 15, further comprising:
determining (S1620) one or more defect scenarios (510, 520, 530) among a plurality of defect scenarios (510, 520, 530) related to the quality of the material produced by the 3D package apparatus; and
changing at least one of the operation of the 3D package apparatus or quality information related to the quality of the material based on the one or more defect scenarios (510, 520, 530).

17. A computer program stored in a computer-readable medium provided to execute the method according to any one of claims 11 to 16 on a computer.

## Patentansprüche

1. Verpackungssimulationsvorrichtung zur Sekundärbatterieproduktion, wobei die Simulationsvorrichtung (100) umfasst:
a) einen Speicher (1720), der konfiguriert ist, um mindestens eine Anweisung zu speichern; und
b) mindestens einen Prozessor, der konfiguriert ist, um die mindestens eine Anweisung, die in dem Speicher (1720) gespeichert ist, auszuführen, um Operationen durchzuführen, die umfassen:
b1) Ausführen (S1310, 1410) einer Vorrichtungsbetriebseinheit (130, 210), die eine 3D-Verpackungsvorrichtung umfasst, die sich auf eine Sekundärbatterieproduktion bezieht, wobei die Vorrichtungsbetriebseinheit (130, 210) eine Softwaremodulvorrichtungsbetriebseinheit (130, 210) ist und die 3D-Verpackungsvorrichtung eine virtuelle 3D-Verpackungsvorrichtung ist;
b2) Prüfen (S1310, 1410) einer Qualität eines Materials, das durch die 3D-Verpackungsvorrichtung produziert wird;
b3) Ausführen (S1310) einer Anlagenbetriebseinheit (120), die eine Vielzahl von Anpassungsparametern zum Bestimmen eines Betriebs der 3D-Verpackungsvorrichtung umfasst, wobei die Anlagenbetriebseinheit (120) eine Softwaremodulanlagenbetriebseinheit (120) ist;
b4) Erhalten (S1320, 1420) von mindestens ersten Benutzeraktionsinformationen, die durch die Vorrichtungsbetriebseinheit (130, 210) erhalten werden, und/oder ersten Benutzerbedingungsinformationen, die durch die Anlagenbetriebseinheit (120) erhalten werden;
b5) Bestimmen (S1330, 1430) einer Materialprüfung und/oder des Betriebs der 3D-Verpackungsvorrichtung und/oder einer Selbstinspektion basierend auf den ersten Benutzeraktionsinformationen und/oder den ersten Benutzerbedingungsinformationen;
b6) Erzeugen eines Defektszenarios (1122) basierend auf Fehlerinformationen (1112) von einer tatsächlichen Vorrichtung (1110); und
b7) Ausführen (S1340, 1440) des Betriebs der 3D-Verpackungsvorrichtung.

2. Vorrichtung (420, 1110) nach Anspruch 1, wobei die Materialprüfung ein Prüfen einer Leitung und/oder eines Aluminiumbeutels und/oder eines Isolierbands umfasst.

3. Vorrichtung (420, 1110) nach Anspruch 1 oder 2, wobei die Operationen ferner ein Durchführen eines Zellableiter-Schweißens und/oder eines Aluminiumbeutelformens und/oder eines Zelleinsetzens und/oder eines Elektrolytfüllens und/oder eines V-Abdichtens umfassen.

4. Vorrichtung (420, 1110) nach einem der Ansprüche 1 bis 3, wobei die Operationen ferner ein Prüfen einer Schweißzugfestigkeit und/oder eines Zellableiter-Zustands und/oder einer Zellableiter-Position und/oder einer Leitungsfilm-Vorsprungs Position und/oder einer Leitungsmitte und/oder einer Dichtungsposition (710) und/oder einer Dichtungsdicke und/oder einer Terrassenbreite und/oder eines Becherdichtungsspalts umfassen.

5. Vorrichtung (420, 1110) nach einem der Ansprüche 1 bis 4, wobei die Operationen ferner umfassen:
Bestimmen eines oder mehrerer Qualitätsparameter zum Bestimmen der Qualität des Materials, das durch die 3D-Verpackungsvorrichtung produziert wird;
Berechnen (S1530) eines Werts, der dem einen oder den mehreren Qualitätsparametern entspricht, basierend auf dem Betrieb der 3D-Verpackungsvorrichtung; und
Ausgeben von Qualitätsinformationen, die sich auf die Qualität des Materials beziehen, das durch die 3D-Verpackungsvorrichtung produziert wird, basierend auf dem Wert, der dem einen oder den mehreren Qualitätsparametern entspricht.

6. Vorrichtung (420, 1110) nach einem der Ansprüche 1 bis 4, wobei die Operationen ferner umfassen:
Bestimmen (1620) eines oder mehrerer Defektszenarien (510, 520, 530), die sich auf die Qualität des Materials beziehen, das durch die 3D-Verpackungsvorrichtung produziert wird; und
Ändern des Betriebs der 3D-Verpackungsvorrichtung und/oder von Qualitätsinformationen, die sich auf die Qualität des Materials beziehen, basierend auf dem einen oder den mehreren Defektszenarien (510, 520, 530).

7. Vorrichtung (420, 1110) nach Anspruch 6, wobei das eine oder die mehreren Defektszenarien (510, 520, 530) ein Dichtungsrillendefektszenario, in dem eine x-Achsenrillenposition des Materials außerhalb einer Grenze (810) einer voreingestellten Spezifikation liegt, ein erstes Dichtungsdickendefektszenario, in dem eine Dichtungsdicke in mindestens einem Messpunkt unter mehreren Messpunkten (910, 920, 930, 1010, 1020, 1030) des Materials außerhalb einer Obergrenze oder einer Untergrenze der voreingestellten Spezifikation liegt und eine Abweichung der Dichtungsdicken zwischen den mehreren Messpunkten (910, 920, 930, 1010, 1020, 1030) kleiner oder gleich einem voreingestellten Referenzwert ist, und/oder ein zweites Dichtungsdickendefektszenario, in dem die Dichtungsdicke in dem mindestens einen Messpunkt unter den mehreren Messpunkten (910, 920, 930, 1010, 1020, 1030) des Materials außerhalb der Obergrenze oder der Untergrenze der voreingestellten Spezifikation liegt und die Abweichung der Dichtungsdicken zwischen den mehreren Messpunkten (910, 920, 930, 1010, 1020, 1030) größer als der voreingestellte Referenzwert ist, umfassen.

8. Vorrichtung (420, 1110) nach Anspruch 7, wobei die Operationen ferner umfassen:
Ausführen des Dichtungsrillendefektszenarios und/oder des ersten Dichtungsdickendefektszenarios und/oder des zweiten Dichtungsdickendefektszenarios;
Erhalten (1510) von zweiten Benutzeraktionsinformationen zum Berühren oder Ziehen von mindestens einem Teil eines Bereichs der 3D-Verpackungsvorrichtung und/oder zweiten Benutzerbedingungsinformationen zum Ändern eines der Vielzahl von Anpassungsparametern der Anlagenbetriebseinheit (120);
Korrigieren (S1520) der 3D-Verpackungsvorrichtung basierend auf den zweiten Benutzeraktionsinformationen und/oder den zweiten Benutzerbedingungsinformationen;
Berechnen (S1530) eines Werts, der einem oder mehreren Qualitätsparametern entspricht, die sich auf die Qualität des Materials beziehen, das durch die korrigierte 3D-Verpackungsvorrichtung produziert wird; und
Korrigieren (S1540) von Qualitätsinformationen, die sich auf die Qualität des Materials beziehen, das durch eine korrigierte 3D-Verpackungsvorrichtung produziert wird, basierend auf dem Wert, der dem einen oder den mehreren Qualitätsparametern entspricht.

9. Vorrichtung (420, 1110) nach Anspruch 7 oder 8, wobei die Operationen ferner umfassen:
Erhalten von dritten Benutzeraktionsinformationen zum Berühren oder Ziehen von mindestens einem Teil eines Bereichs, der einer Qualitätsprüfung des Materials entspricht, das durch die 3D-Verpackungsvorrichtung produziert wird; und
Ausgeben einer Defektursache des Materials basierend auf den dritten Benutzeraktionsinformationen.

10. Vorrichtung (420, 1110) nach einem der Ansprüche 7 bis 9, wobei die Operationen ferner ein Ausgeben von Anleitungsinformationen umfassen, die Bedingungsinformationen und Aktionsinformationen umfassen, die sich auf das Auflösen des einen oder der mehreren Defektszenarien (510, 520, 530) beziehen.

11. Verpackungssimulationsverfahren zur Sekundärbatterieproduktion, wobei das Verfahren durch mindestens einen Prozessor ausgeführt wird, wobei das Verfahren umfasst:
a) Ausführen (S1310, 1410) einer Vorrichtungsbetriebseinheit (130, 210), die eine 3D-Verpackungsvorrichtung umfasst, die sich auf eine Sekundärbatterieproduktion bezieht, wobei die Vorrichtungsbetriebseinheit (130, 210) eine Softwaremodulvorrichtungsbetriebseinheit (130, 210) ist und die 3D-Verpackungsvorrichtung eine virtuelle 3D-Verpackungsvorrichtung ist;
b) Prüfen (S1310, 1410) einer Qualität eines Materials, das durch die 3D-Verpackungsvorrichtung produziert wird;
c) Ausführen (S1310, 1410) einer Anlagenbetriebseinheit (120), die eine Vielzahl von Anpassungsparametern zum Bestimmen eines Betriebs der 3D-Verpackungsvorrichtung umfasst, wobei die Anlagenbetriebseinheit (120) eine Softwaremodulanlagenbetriebseinheit (120) ist;
d) Erhalten (S1320, 1420) von ersten Benutzeraktionsinformationen, die durch die Vorrichtungsbetriebseinheit (130, 210) erhalten werden, und/oder ersten Benutzerbedingungsinformationen, die durch die Anlagenbetriebseinheit (120) erhalten werden;
e) Bestimmen (S1330, 1430) einer Materialprüfung und/oder des Betriebs der 3D-Verpackungsvorrichtung und/oder einer Selbstinspektion basierend auf den ersten Benutzeraktionsinformationen und/oder den ersten Benutzerbedingungsinformationen;
f) Erzeugen eines Defektszenarios (1122) basierend auf Fehlerinformationen (1112) von einer tatsächlichen Vorrichtung (1110); und
g) Ausführen (S1340, 1440) des Betriebs der 3D-Verpackungsvorrichtung.

12. Verfahren nach Anspruch 11, wobei, wenn die bestimmte Operation die Materialprüfung ist, das Ausführen der bestimmten Operation ein Prüfen einer Leitung und/oder eines Aluminiumbeutels und/oder eines Isolierbands umfasst.

13. Verfahren nach Anspruch 11 oder 12, wobei, wenn die bestimmte Operation der Betrieb der 3D-Verpackungsvorrichtung ist, das Ausführen der bestimmten Operation ein Betrieb eines Zellableiter-Schweißens und/oder eines Aluminiumbeutelformens und/oder eines Zelleinsetzens und/oder eines Elektrolytfüllens und/oder eines V-Abdichtens umfasst.

14. Verfahren nach einem der Ansprüche 11 bis 13, wobei, wenn die bestimmte Operation die Selbstinspektion ist, das Ausführen der bestimmten Operation ein Prüfen einer Schweißzugfestigkeit und/oder eines Zellableiter-Zustands und/oder einer Zellableiter-Position und/oder einer Leitungsfilm-Vorsprungsposition und/oder einer Leitungsmitte und/oder einer Dichtungsposition (710) und/oder einer Dichtungsdicke und/oder einer Terrassenbreite und/oder eines Becherdichtungsspalts umfasst.

15. Verfahren nach einem der Ansprüche 11 bis 14, ferner umfassend:
Bestimmen eines oder mehrerer Qualitätsparameter zum Bestimmen der Qualität des Materials, das durch die 3D-Verpackungsvorrichtung produziert wird;
Berechnen (S1530) eines Werts, der dem einen oder den mehreren Qualitätsparametern entspricht, basierend auf dem Betrieb der 3D-Verpackungsvorrichtung; und
Ausgeben von Qualitätsinformationen, die sich auf die Qualität des Materials beziehen, das durch die 3D-Verpackungsvorrichtung produziert wird, basierend auf dem Wert, der dem einen oder den mehreren Qualitätsparametern entspricht.

16. Verfahren nach einem der Ansprüche 11 bis 15, ferner umfassend:
Bestimmen (S1620) eines oder mehrerer Defektszenarien (510, 520, 530) aus einer Vielzahl von Defektszenarien (510, 520, 530), die sich auf die Qualität des Materials beziehen, das durch die 3D-Verpackungsvorrichtung produziert wird; und
Ändern des Betriebs der 3D-Verpackungsvorrichtung und/oder von Qualitätsinformationen, die sich auf die Qualität des Materials beziehen, basierend auf dem einen oder den mehreren Defektszenarien (510, 520, 530).

17. Computerprogramm, das in einem computerlesbaren Medium gespeichert ist, das bereitgestellt ist, um das Verfahren nach einem der Ansprüche 11 bis 16 auf einem Computer auszuführen.

## Revendications

1. Dispositif de simulation de conditionnement pour la production de batteries secondaires, ledit dispositif de simulation (100) comprenant :
a) une mémoire (1720) configurée pour stocker au moins une instruction ; et
b) au moins un processeur (1710) configuré pour exécuter ladite au moins une instruction stockée en mémoire (1720) afin d'effectuer des opérations comprenant :
b1) l'exécution (S1310, S1410) d'une unité d'exploitation de dispositif (130, 210) comprenant un dispositif de conditionnement 3D associé à la production de batteries secondaires, ladite unité d'exploitation de dispositif (130, 210) étant une unité d'exploitation de dispositif à module logiciel (130, 210) et le dispositif de conditionnement 3D étant un dispositif de conditionnement 3D virtuel ;
b2) le contrôle (S1310, S1410) de la qualité d'un matériel produit par le dispositif de conditionnement 3D ;
b3) l'exécution (S1310, S1410) d'une unité d'exploitation d'installation (120) comprenant une pluralité de paramètres de réglage pour déterminer une opération du dispositif de conditionnement 3D, ladite unité d'exploitation d'installation (120) étant une unité d'exploitation d'installation à module logiciel (120) ;
b4) l'obtention (S1320, S1420) de premières informations d'action d'utilisateur obtenues par l'unité d'exploitation de dispositif (130, 210) et/ou de premières informations d'état d'utilisateur obtenues par unité d'exploitation d'installation (120) ;
b5) la détermination (S1330, S1430) d'un contrôle de matériel et/ou de l'opération du dispositif de conditionnement 3D et/ou d'une auto-inspection sur la base des premières informations d'action d'utilisateur et/ou des premières informations d'état d'utilisateur ;
b6) la génération d'un scénario de défaut (1122) sur la base d'informations d'erreur (1112) provenant d'un dispositif effectif (1110) ; et
b7) l'exécution (S1340, S1440) de l'opération du dispositif de conditionnement 3D.

2. Dispositif (100) selon la revendication 1, où le contrôle du matériel comprend le contrôle de plomb et/ou de sac en aluminium et/ou de bande isolante.

3. Dispositif (100) selon la revendication 1 ou la revendication 2, où les opérations comprennent en outre l'exécution d'une soudure de languette, et/ou la formation de sacs en aluminium, et/ou l'insertion de cellules, et/ou le versement d'électrolyte et/ou le scellement en V.

4. Dispositif (100) selon l'une des revendications 1 à 3, où les opérations comprennent en outre une inspection de résistance à la traction de soudage, et/ou d'état de languette, et/ou de position de languette, et/ou de position en saillie de film de plomb, et/ou de centre du plomb, et/ou de position d'étanchéité (710), et/ou d'épaisseur d'étanchéité, et/ou de largeur de terrasse, et/ou d'espace d'étanchéité de batterie.

5. Dispositif (100) selon l'une des revendications 1 à 4, où les opérations comprennent en outre :
la détermination d'un ou de plusieurs paramètres de qualité pour déterminer la qualité du matériel produit par le dispositif de conditionnement 3D ;
le calcul (S1530) d'une valeur correspondant au paramètre, ou aux plusieurs paramètres de qualité sur la base de l'opération du dispositif de conditionnement 3D ; et
l'émission d'informations de qualité relatives à la qualité du matériel produit par le dispositif de conditionnement 3D sur la base de la valeur correspondant au paramètre, ou aux plusieurs paramètres de qualité.

6. Dispositif (100) selon l'une des revendications 1 à 4, où les opérations comprennent en outre :
la détermination (S1620) d'un ou de plusieurs scénarios de défauts (510, 520, 530) relatifs à la qualité du matériel produit par le dispositif de conditionnement 3D ; et
la modification de l'opération du dispositif de conditionnement 3D et/ou des informations de qualité relatives à la qualité du matériel sur la base d'un ou de plusieurs scénarios de défauts (510, 520, 530).

7. Dispositif (100) selon la revendication 6, où le ou les scénarios de défauts (510, 520, 530) comprennent un scénario de défaut de rainure d'étanchéité où une position de rainure sur l'axe des abscisses du matériel est en dehors d'une limite (810) d'une spécification prédéfinie, et/ou un premier scénario de défaut d'épaisseur d'étanchéité où une épaisseur d'étanchéité sur au moins un point de mesure parmi une pluralité de points de mesure (910, 920, 930, 1010, 1020, 1030) du matériel est en dehors d'une limite supérieure ou d'une limite inférieure de la spécification prédéfinie, ou un écart dans les épaisseurs d'étanchéité entre les plusieurs points de mesure (910, 920, 930, 1010, 1020, 1030) est inférieur ou égal à une valeur de référence prédéfinie, et/ou un deuxième scénario de défaut d'épaisseur d'étanchéité où l'épaisseur d'étanchéité sur au moins un point de mesure parmi la pluralité de points de mesure (910, 920, 930, 1010, 1020, 1030) du matériel est en dehors de la limite supérieure ou de la limite inférieure de la spécification prédéfinie, et l'écart dans les épaisseurs d'étanchéité entre les plusieurs points de mesure (910, 920, 930, 1010, 1020, 1030) est supérieur à la valeur de référence prédéfinie.

8. Dispositif (100) selon la revendication 7, où les opérations comprennent en outre :
l'exécution du scénario de défaut de rainure d'étanchéité, et/ou du premier scénario de défaut d'épaisseur d'étanchéité, et/ou du deuxième scénario de défaut d'épaisseur d'étanchéité ;
l'obtention (S1510) de deuxièmes informations d'action d'utilisateur consistant à toucher ou faire glisser au moins une partie d'une zone du dispositif de conditionnement 3D, et/ou de deuxièmes informations d'état d'utilisateur consistant à modifier un paramètre parmi la pluralité de paramètres de réglage de l'unité d'exploitation d'installation (120) ;
la correction (S1520) du dispositif de conditionnement 3D sur la base des deuxièmes informations d'action d'utilisateur et/ou des deuxièmes informations d'état d'utilisateur ;
le calcul (S1530) d'une valeur correspondant à un ou plusieurs paramètres de qualité relatifs à la qualité du matériel produit par le dispositif de conditionnement 3D corrigé ; et
la correction (S1540) des informations de qualité relatives à la qualité du matériel produit par un dispositif de conditionnement 3D corrigé sur la base de la valeur correspondant au paramètre, ou aux plusieurs paramètres de qualité.

9. Dispositif (100) selon la revendication 7 ou la revendication 8, où les opérations comprennent en outre :
l'obtention de troisièmes informations d'action d'utilisateur consistant à toucher ou faire glisser au moins une partie d'une zone correspondant à un contrôle de qualité du matériel produit par le dispositif de conditionnement 3D ; et
l'émission d'une cause de défaut du matériel sur la base des troisièmes informations d'action d'utilisateur.

10. Dispositif (100) selon l'une des revendications 7 à 9, où les opérations comprennent en outre l'émission d'informations de guidage comprenant des informations d'état et des informations d'action relatives à la résolution d'un ou de plusieurs scénarios de défaut (510, 520, 530).

11. Procédé de simulation de conditionnement pour la production de batteries secondaires, ledit procédé étant exécuté par au moins un processeur, ledit procédé comprenant :
a) l'exécution (S1310, S1410) d'une unité d'exploitation de dispositif (130, 210) comprenant un dispositif de conditionnement 3D associé à la production de batteries secondaires, ladite unité d'exploitation de dispositif (130, 210) étant une unité d'exploitation de dispositif à module logiciel (130, 210) et le dispositif de conditionnement 3D étant un dispositif de conditionnement 3D virtuel ;
b) le contrôle (S1310, S1410) de la qualité d'un matériel produit par le dispositif de conditionnement 3D ;
c) l'exécution (S1310, S1410) d'une unité d'exploitation d'installation (120) comprenant une pluralité de paramètres de réglage pour déterminer une opération du dispositif de conditionnement 3D, ladite unité d'exploitation d'installation (120) étant une unité d'exploitation d'installation à module logiciel (120) ;
d) l'obtention (S1320, S1420) de premières informations d'action d'utilisateur obtenues par l'unité d'exploitation de dispositif (130, 210) et/ou de premières informations d'état d'utilisateur obtenues par unité d'exploitation d'installation (120) ;
e) la détermination (S1330, S1430) d'un contrôle de matériel et/ou de l'opération du dispositif de conditionnement 3D et/ou d'une auto-inspection sur la base des premières informations d'action d'utilisateur et/ou des premières informations d'état d'utilisateur ;
f) la génération d'un scénario de défaut (1122) sur la base d'informations d'erreur (1112) provenant d'un dispositif effectif (1110) ; et
g) l'exécution (S1340, S1440) de l'opération du dispositif de conditionnement 3D.

12. Procédé selon la revendication 11, où, si l'opération déterminée est le contrôle du matériel, l'exécution de l'opération déterminée comprend le contrôle de plomb et/ou de sac en aluminium et/ou de bande isolante.

13. Procédé selon la revendication 11 ou la revendication 12, où, si l'opération déterminée est l'actionnement du dispositif de conditionnement 3D, l'exécution de l'opération déterminée comprend l'exécution d'une soudure de languette, et/ou la formation de sacs en aluminium, et/ou l'insertion de cellules, et/ou le versement d'électrolyte et/ou le scellement en V.

14. Procédé selon l'une des revendications 11 à 13, où, si l'opération déterminée est l'auto-inspection, l'exécution de l'opération déterminée comprend une inspection de résistance à la traction de soudage, et/ou d'état de languette, et/ou de position de languette, et/ou de position en saillie de film de plomb, et/ou de centre du plomb, et/ou de position d'étanchéité (710), et/ou d'épaisseur d'étanchéité, et/ou de largeur de terrasse, et/ou d'espace d'étanchéité de batterie.

15. Procédé selon l'une des revendications 11 à 14, comprenant en outre :
la détermination d'un ou de plusieurs paramètres de qualité pour déterminer la qualité du matériel produit par le dispositif de conditionnement 3D ;
le calcul (S1530) d'une valeur correspondant au paramètre, ou aux plusieurs paramètres de qualité sur la base de l'opération du dispositif de conditionnement 3D ; et
l'émission d'informations de qualité relatives à la qualité du matériel produit par le dispositif de conditionnement 3D sur la base de la valeur correspondant au paramètre, ou aux plusieurs paramètres de qualité.

16. Procédé selon l'une des revendications 11 à 15, comprenant en outre :
la détermination (S1620) d'un ou de plusieurs scénarios de défauts (510, 520, 530) relatifs à la qualité du matériel produit par le dispositif de conditionnement 3D ; et
la modification de l'opération du dispositif de conditionnement 3D et/ou des informations de qualité relatives à la qualité du matériel sur la base d'un ou de plusieurs scénarios de défauts (510, 520, 530).

17. Programme informatique enregistré sur un support lisible par ordinateur, prévu pour exécuter le procédé selon l'une des revendications 11 à 16 sur un ordinateur.
